# EUROPEAN PATENT SPECIFICATION

(11) **EP 4 332 751 B1**
(45) Date of publication and mention of the grant of the patent: **25.11.2026**
(21) Application number: 23187531.1
(22) Date of filing: 25.07.2023
(51) Int. Cl.: G06F 7/544, G06N 3/063, G11C 11/54

(54) **APPARATUS AND METHOD WITH IN-MEMORY COMPUTING (IMC)**
VORRICHTUNG UND VERFAHREN MIT SPEICHERINTERNER DATENVERARBEITUNG (IMC)
APPAREIL ET PROCÉDÉ AVEC CALCUL EN MÉMOIRE (IMC)

(30) Priority: 30.08.2022 KR 20220109261; 12.07.2023 US 202318351039; 18.07.2023 KR 20230093290
(43) Date of publication of application: 06.03.2024
(73) Proprietor: Samsung Electronics Co., Ltd., Suwon-si, Gyeonggi-do 16677 (KR)
(72) Inventor: Yun, Seok Ju, Suwon-si, Gyeonggi-do (KR); Lee, Jaehyuk, Suwon-si, Gyeonggi-do (KR); Jung, Seungchul, Suwon-si, Gyeonggi-do (KR); Kwon, Soon-Wan, Suwon-si, Gyeonggi-do (KR); Myung, Sungmeen, Suwon-si, Gyeonggi-do (KR); Yoon, Daekun, Suwon-si, Gyeonggi-do (KR); Chang, Dong-Jin, Suwon-si, Gyeonggi-do (KR)
(74) Representative: Grünecker Patent- und Rechtsanwälte PartG mbB

(56) References cited:
- US-A1- 2020 294 575
- US-A1- 2022 107 803
- US-B1- 11 176 991
- KIM DONGHYUK ET AL: "An Overview of Processing-in-Memory Circuits for Artificial Intelligence and Machine Learning", IEEE JOURNAL ON EMERGING AND SELECTED TOPICS IN CIRCUITS AND SYSTEMS, IEEE, PISCATAWAY, NJ, USA, vol. 12, no. 2, 17 March 2022 (2022-03-17), pages 338 - 353, XP011911074, ISSN: 2156-3357, [retrieved on 20220317], DOI: 10.1109/JETCAS.2022.3160455

## Description

### BACKGROUND

### 1. Field

The following description relates to a method and apparatus with in-memory computing (IMC).

### 2. Description of Related Art

Various types of neural network (NN)s trained through machine learning and/or deep learning may be used in many application fields to provide high performance, with respect to, for example, accuracy, speed, and/or energy efficiency. Algorithms that enable the machine learning and inferencing of NNs often require very large amounts of computation. However, learning and inferencing algorithms may be performed by the processing of many less-complex operations such as, for example, multiply-accumulate (MAC) operations that use the dot product of two vectors and the cumulative sum of their values. Less complex operations such as MAC operations may be implemented through in-memory computing.
US 2022/107803 A1 discloses a memory device for performing in-memory processing.
US 2020/294575 A1 discloses a memory device for processing operation and method of operating the same.
US 11 176 991 B1 describes compute-in-memory employing low-power compute-in-memory circuits employing SRAM bit cells, particularly for multiply-and-accumulate operations.
D. Kim et al., "An Overview of Processing-in-Memory Circuits for Artificial Intelligence and Machine Learning", IEEE J. on Emerging and Selected Topics in Circuits and Systems, vol. 12, No. 2, pages 338-353 provides an overview of processing-in-memory circuits for artificial intelligence and machine learning.

### SUMMARY

This Summary is provided to introduce a selection of concepts in a simplified form that are further described below in the Detailed Description. This Summary is not intended to identify key features or essential features of the claimed subject matter, and is not intended to be used as an aid in determining the scope of the claimed subject matter.
The invention is claimed in the independent claims. Preferred embodiments are specified in the dependent claims.
In one general aspect, an in-memory computing (IMC) circuit, includes a plurality of memory banks, each memory bank including a bit cell configured to store a weight value and an operator configured to receive an input value, the operator being connected to the bit cell such that the operator upon receiving the input value outputs a logic operation result between the input value and the weight value, and a logic gate configured to receive the logic operation result of each of the memory banks.

The logic operation result of each of the memory banks may be a NAND operation value for the input value and the weight value.

The logic gate may be a NAND gate.

The logic gate may output a multiplication result between a weight value and an input value of a memory bank selected among the memory banks.

Each of the memory banks not selected may receive an input value of 0.

The IMC circuit may further include an adder connected to the logic gate.

The operator may include a respective plurality of transistors configured to output a signal corresponding to a result of a bit-wise multiplication operation.

The operator may include a two transistor (2T) circuit including a first transistor and a second transistor, the input value may be applied to a first gate terminal of the first transistor and a second gate terminal of the second transistor, and an output value of the first transistor passing through the first gate terminal may be connected to an output value of the second transistor passing through the second gate terminal, and thereby output the logic operation result.

A value based on the weight value stored in the bit cell may be applied to a drain terminal of the first transistor, and a source terminal of the first transistor may be connected to an input terminal of the logic gate via a drain terminal of the second transistor.

The first transistor may include a negative-metal-oxide semiconductor (NMOS) transistor, and the second transistor may include a positive-MOS (PMOS) transistor.

The operator may include a three transistor (3T) circuit including a transmission gate and a third transistor, the input value may be applied to an enable terminal of the transmission gate and a third gate terminal of the third transistor, and each of an output value of the transmission gate and an output value of the third transistor passing through the third gate terminal may be connected to the input of the gate logic circuit, and thereby output the logic operation result.

The logic gate may be configured to transfer, to the adder, the logic operation result corresponding to the bit cell, according to whether the input value is applied to the operator.

The IMC circuit may be integrated into at least one device selected from a group including: a mobile device, a mobile computing device, a mobile phone, a smartphone, a personal digital assistant, a fixed location terminal, a tablet computer, a computer, a wearable device, a laptop computer, a server, a music player, a video player, an entertainment unit, a navigation device, a communication device, a global positioning system (GPS) device, a television, a tuner, an automobile, a vehicle part, an avionics system, a drone, a multi-copter, and a medical device.

In one general aspect, a neural network apparatus includes an IMC circuit, the apparatus includes an array circuit including IMC circuits, and a controller configured to: input second values corresponding to an input signal of the neural network apparatus to each of the IMC circuits according to a clock signal, and control the plurality of IMC circuits. Each of the IMC circuits may include a plurality of memory banks, each memory bank including a bit cell configured to store a weight value and an operator configured to receive an input value, the operator being connected to the bit cell such that the operator upon receiving the input value outputs a logic operation result between the input value and the weight value, and a logic gate configured to receive the logic operation result of each of the memory banks.

The logic operation result of each of the memory banks may be a NAND operation value for the input value and the weight value.

The logic gate may be a NAND gate.

The controller may include any one or any combination of an input feature map (IFM) buffer configured to store an input feature map including the input value, a control circuit configured to control whether the input value is applied to the plurality of IMC circuits, and a read write (RW) circuit configured to read or write the weight value.

In one general aspect, an IMC apparatus includes memory banks, each including a respective bit cell unit, each bit cell unit including a bit cell and an operator, wherein none of the bit cells share a same operator, a logic gate configured to receive outputs of the operators of the respective bit cell units, and an adder configured to receive an output of the logic gate to perform at least part of a multiply-accumulate (MAC) operation.

An output of each of the respective bit cell units may be connected to the logic gate, and each of the bit cells may be configured to store a respective stored value, wherein the bit cell units are connected to respective input lines configured to provide respective input values to the bit cell units, wherein the IMC apparatus is configured such that the input values provided to the bit cell units select which one of the bit cell units is a target for an operation to be performed on its stored value by its operator.

The stored values of the bit cell units that are not the target for the operation may not affect an output of the logic gate.

Other features and aspects will be apparent from the following detailed description, the drawings, and the claims.

### BRIEF DESCRIPTION OF THE DRAWINGS

FIG. 1 illustrates an example of a neural network whose operations may be performed by in an in-memory computing (IMC) circuit, according to one or more embodiments.
FIGS. 2A to 2D illustrate an example IMC circuit structure, according to one or more embodiments.
FIG. 3 illustrates an example operation of an IMC circuit including four memory banks, according to one or more embodiments.
FIG. 4 illustrates an example IMC circuit, according to one or more embodiments.
FIGS. 5A and 5B illustrate example operations of an IMC circuit composed of two transistors, according to one or more embodiments.
FIGS. 6A and 6B illustrate an example of an IMC circuit selecting a memory bank, according to one or more embodiments.
FIG. 7 illustrates example operations of an IMC operator circuit composed of three transistors, according to one or more embodiments.
FIG. 8 illustrates another example of operations of an IMC operator circuit composed of three transistors, according to one or more embodiments.
FIG. 9 illustrates an example of a neural network apparatus including an IMC circuit, according to one or more embodiments.
FIG. 10 illustrates an example of an electronic system including a neural network apparatus, according to one or more embodiments.
FIG. 11 illustrates an example of a method of operating an IMC circuit, according to one or more embodiments.

Throughout the drawings and the detailed description, unless otherwise described or provided, the same or like drawing reference numerals will be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As nonlimiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other components or elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

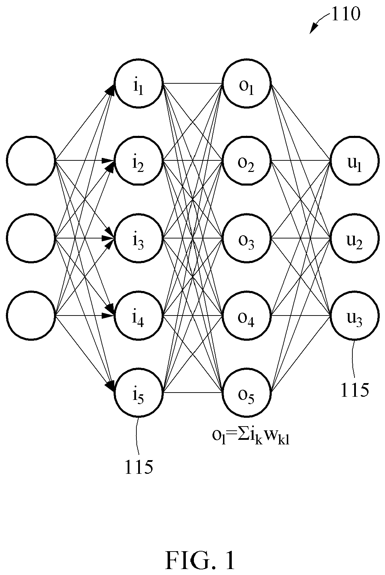

FIG. 1 illustrates an example of a neural network whose operations may be performed by an in-memory computing (IMC) circuit, according to one or more embodiments. Referring to FIG. 1, a neural network 110 whose operations may be performed by an IMC circuit is illustrated.

An IMC circuit or device may have a computing architecture that allows an operation to be performed directly inside a memory in which data is stored. IMC devices may function as both memory devices and computation (operation) devices. Regarding the memory function, an IMC device has memory, that is, memory circuitry, which is often dynamic (although not exclusively), to which external data may be written and stored in the memory, and which can be read-from externally and also used internally (in-place) for computation (operation) by the computation function of the IMC device. Regarding the computation (operation) function, an IMC device also has computation or operation circuitry that performs operations (e.g., MAC operations) on the data in-place, i.e., as stored in the memory, and which externally outputs results of such computation. IMC devices are, for many applications, able to surpass performance and power limitations caused by frequent data movements between the memory and arithmetic units (e.g., processors) of Von Neumann architecture devices, for example. IMC circuits are generally one of two categories, namely, analog IMC circuits and digital IMC circuits, according to which domain an operation is to be performed in. An analog IMC circuit may, for example, perform an operation in an analog domain such as current, electric charge, time, and the like. A digital IMC circuit may use a logic circuit to perform an operation in a digital domain. The examples below describe digital IMC circuits.

An IMC circuit may accelerate a matrix operation and/or a multiply-accumulate (MAC) operation that adds multiple multiplications, which is highly common for artificial intelligence (AI) learning and inferencing. MAC operations for learning or inferencing of the neural network 110 may be performed through the memory array 130, which includes bit cells of a memory device in the IMC circuit. Hereinafter, for convenience of description, an example in which the neural network 110 includes fully connected layers will be described, but implementations are not limited thereto. The neural network 110 may be a convolutional neural network including convolution layers. The IMC circuit may enable machine learning and inferencing of the neural network 110 by performing the corresponding MAC operations via operation functions by a memory array which includes the bit cells and operators.

The neural network 110 may be, for example, a deep neural network (DNN) including two or more hidden layers, i.e., an n-layer neural network. The neural network 110 may include an input layer (Layer 1), two hidden layers (Layer 2 and Layer 3), and an output layer (Layer 4); the neural network 110 is only an example and embodiments described herein are not limited to any particular types or configurations of neural networks. For example, when the neural network 110 is implemented with a DNN architecture, the neural network 110 may include a greater number of layers that may process valid information, and may thus process more complex data sets than a neural network having a single layer. Although the neural network 110 is illustrated in FIG. 1 as including four layers, this is merely an example, and the neural network 110 may include fewer or more layers or channels. That is, the neural network 110 may include layers of various structures different from what is illustrated in FIG. 1.

Each of the layers included in the neural network 110 may include a respective plurality of nodes 115. A node is also sometimes referred to as a neuron, a processing element (PE), a unit, a channel, or other similar terms. The example neural network 110 shown in FIG. 1 includes, for example, an input layer including three nodes, two hidden layers respectively including five nodes, and an output layer including three nodes. The nodes 115 included in each of the layers of the neural network 110 may be connected to one another to process data. For example, one node may receive data from other nodes to perform an operation, and may output a result of the operation to other nodes.

Nodes 115 of one layer may be connected to the nodes of another layer through connections which may have respective weights w. For example, an output o₁ of one node may be determined based on (i) input values (e.g., i₁, i₂, i₃, i₄, i₅) propagated from other nodes of a previous layer connected to the node and on (ii) weights w₁₁, w₂₁, w₃₁, w₄₁ and w₅₁ of connections to the node.

For example, an *l*-th output *oₗ* among L output values may be represented by Equation 1 below. In this example, L may be an integer greater than or equal to "1", and *l* may be an integer greater than or equal to "1" and less than or equal to "L". ${o}_{l} = \sum {i}_{k} {w}_{kl}$ Equation 1

In Equation 1, *iₖ* denotes a k-th input among P inputs, and *wₖₗ* denotes a weight set between the k-th input and the *l*-th output. P is an integer greater than or equal to "1", and k is an integer greater than or equal to "1" and less than or equal to "P".

In other words, the input and output between the nodes 115 in the neural network 110 may be expressed as a weighted sum between input i and weight w. The weighted sum operation may be implemented as a multiplication operation and an iterative accumulation operation between a plurality of inputs and a plurality of weights, and may also be referred to as a "MAC operation". Since the MAC operation is performed using a memory provided with an operation function (e.g., circuitry that performs computation or performs the operation function), a circuit configured to perform the MAC operation may be referred to as an "IMC circuit".

The neural network 110 may, for example, perform a weighted sum operation in layers based on input data (e.g., i₁, i₂, i₃, i₄, i₅), and generate output data (e.g., u₁, u₂, u₃) based on a result (e.g., o₁, o₂, o₃, o₄, o₅) of performing the operation.

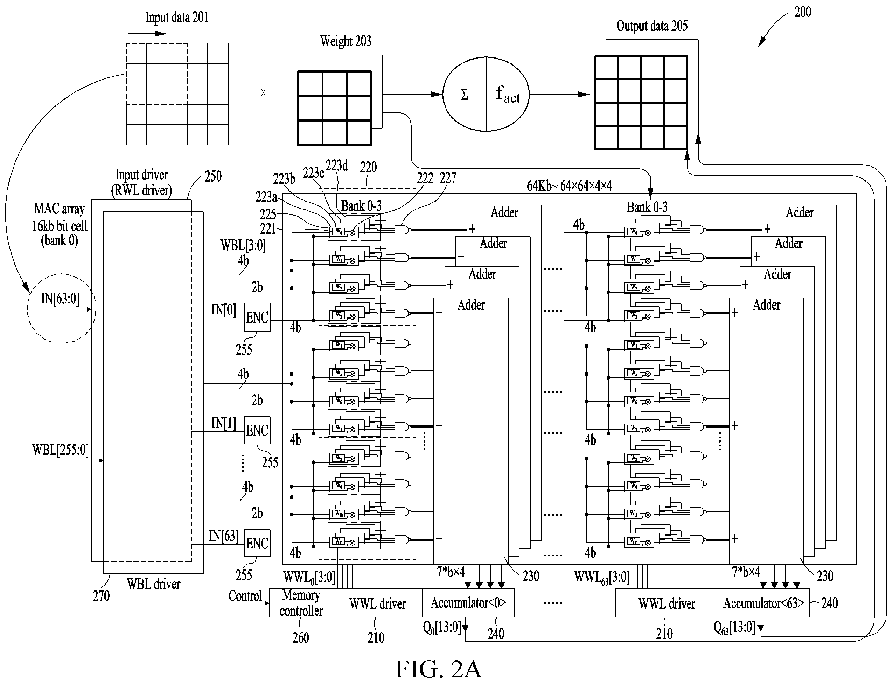

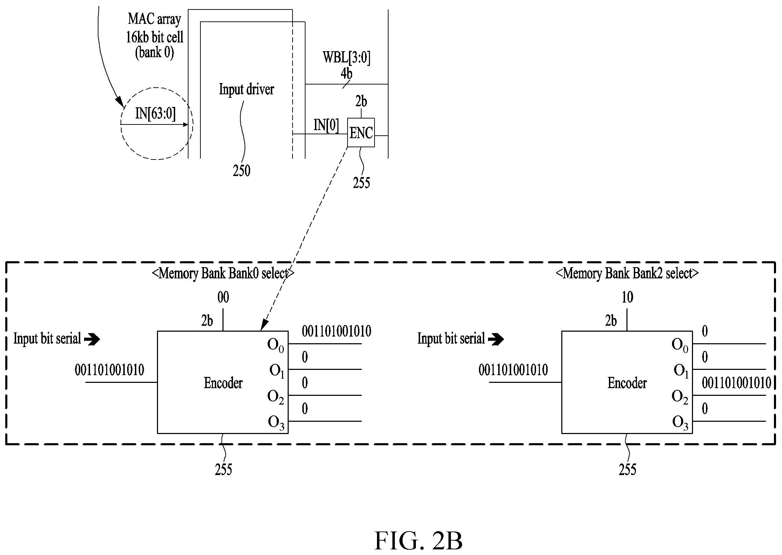

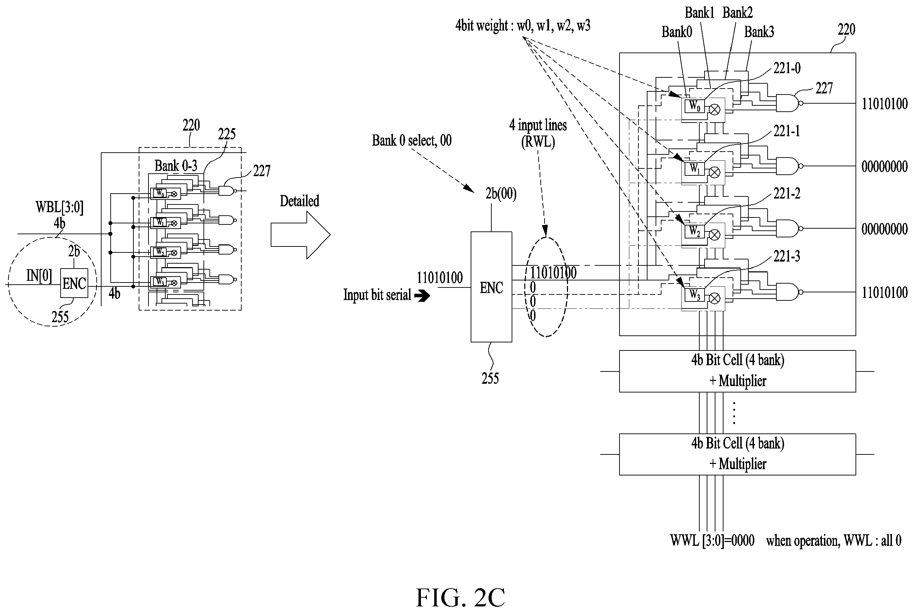

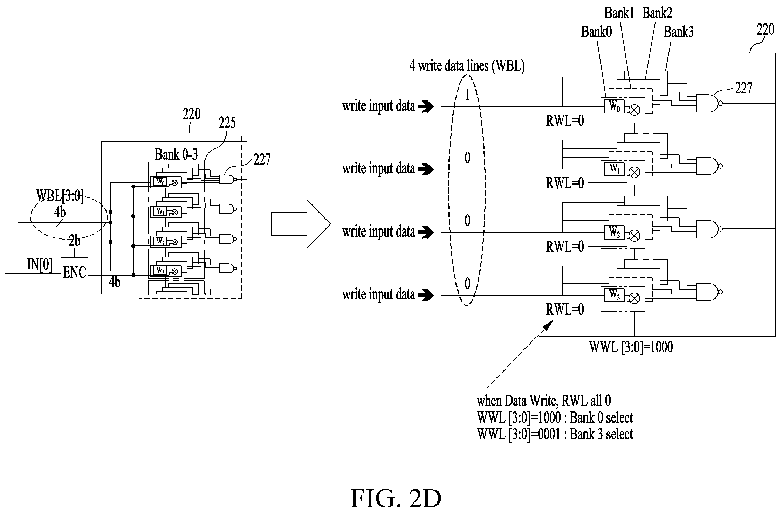

FIGS. 2A, 2B, 2C and 2D illustrate example structure of an IMC macro including an IMC circuit. Referring to FIG. 2A, an IMC macro 200 may include a write word line (WWL) driver 210, an IMC circuit 220, an adder 230, an accumulator 240, an input driver (or read word line (RWL) driver) 250, a memory controller 260, and a write bit line (WBL) driver 270. The IMC macro 200 may be, for example, a 64kb SRAM IMC macro as illustrated in FIG. 2A, but is not limited thereto.

As described next, an IMC circuit (e.g., IMC circuit 220) may include bit cell circuits (e.g., an SRAM bit cell circuit 225), and each bit cell circuit may have bit cell units (e.g., bit cell units 223a-223d). The bit cell units of each bit cell circuit may be included in the respective memory banks of the IMC circuit (e.g., bit cell units 223a-223d may be included in Banks 0-3, respectively). Each bit cell unit may include a bit cell and an operator (e.g., bit cell unit 223a may include bit cell 221 and operator 222). The bit cell circuits of an IMC circuit may also have respective gate logic circuits (e.g., SRAM bit cell circuit 225 may have corresponding gate logic circuit 227). The bit cell units of a bit cell circuit may be respectively connected to the gate logic circuit corresponding to the bit cell circuit (e.g., bit cell units 223a-223d may be connected to the gate logic circuit 227).

As noted above, the IMC circuit 220 may include a gate logic circuit 227 and an SRAM bit cell circuit 225 including bit cells (e.g., bit cell 221) having respective operators arranged in respective memory banks; the operators (e.g., operator 222) output signals corresponding to operation results of operations on each of the respective bit cells. For example, FIG. 2C, shows four SRAM bit cell circuits, which respectively have, in Bank0, bit cells 221-0 to 221-3. That is, bit cell circuits may each be included in 4 memory banks such as memory bank Bank0, memory bank Bank1, memory bank Bank2, and memory bank Bank3. The bit cell units corresponding to the same memory bank (e.g., Bank0) may receive the same input value.

As noted above, for example, in the SRAM bit cell circuit 225, one bit cell 221 corresponding to one memory bank and one operator 222 (that outputs an operation result corresponding to the one bit cell 221) may be referred to as a "bit cell unit 223" in that it is a basic storage and operation unit of the SRAM bit cell circuit 225. One bit cell 221 may have, for example, an 8-transistor (8T) SRAM cell structure for storing a bit value. One operator 222 may have, for example, a two-transistor (2T) circuit for performing an operation. The bit cell unit 223 may have, for example, an SRAM cell structure in which the operators 222 of a two-transistor (2T) circuit are coupled to the bit cells 221 that have an 8-transistor (8T) SRAM cell structure, for a total of 10 transistors (10T). An operator 222 may be, for example, a general logic multiplier or a pass transistor logic. The gate logic circuit 227 may transfer, to the adder 230, an operation result corresponding to each of the bit cells belonging to a target memory bank for a multiply-accumulate (MAC) operation among the bit cells 221 corresponding to the plurality of memory banks.

Hereinafter, for convenience of description, "RWL" and "WWL" are expressed briefly as "WL" (word line), and "WWL driver" and "RWL driver" are expressed briefly as "WL driver" (word line driver). Also, "WBL" is expressed briefly as "BL".

In the IMC macro 200, a digital operation in which all data is expressed as digital logic values "0" and "1" may be performed, and input data 201, a weight 203, and output data 205 may have a binary format. For example, the input data 201 and the weight 203 may be converted to the output data 205 by an activation function (f_{act}). The components described with reference to FIG. 2A to 2D may be implemented as digital logic circuitry.

The RWL may be a path to which the input data 201 is applied, and thus the input driver 250 may also function as the RWL driver. The input driver 250 may transfer the input data 201 (i.e., an external operand) upon which an operation (e.g., a multiplication operation or a convolution operation) of the IMC circuit 220 will be performed. An RWL signal may be determined based on an input value of the input data 201. The input data 201 may be digital data having a multi-bit or single-bit input value.

The input data 201 read through the input driver 250 may be converted into an input signal of the IMC circuit 220 through an encoding (ENC) block 255. The ENC block 255 may provide a signal for selecting a target memory bank for a MAC operation among a plurality of memory banks to the IMC circuit 220 together with the converted input signal. The operation of the input driver 250 is described in more detail with reference to FIG. 2B. In addition, a process in which an operation is performed in the memory banks is described in more detail below with reference to FIG. 2C, and a process of writing data (e.g., a weight value or an input value) read by the WBL driver 270 to the memory banks (bit cells) is described in more detail below with reference to FIG. 2D.

FIG. 2B shows an example of a process by which input data read by the input driver 250 is input to the IMC circuit 220 through the ENC block 255. For example, when the IMC macro 200 is a 64 kb SRAM IMC macro as shown in FIG. 2A, the input driver 250 may read 64 input data such as IN[63:0]. Each of the 64 input data may consist of 4 bits. The input driver 250 may sequentially input the input data 201 (e.g., "0011 0100 1010") composed of 4 bits to the ENC block 255 one bit at a time. The ENC block 255 may transfer the input data 201 (e.g., "0011 0100 1010") to one of 4 memory banks according to a 2-bit control signal (e.g., "00" for Bank0 or "10" for Bank2). Each of the 4 memory banks may correspond to corresponding bit cell.

When a first memory bank (Bank0) is to be used as an operator (i.e., is a target memory bank), the IMC macro 200 may apply a 2-bit control signal "00" to the ENC block 255. As the 2-bit control signal "00" is applied to the ENC block 255, the ENC block 255 may sequentially provide the input data (e.g., "0011 0100 1010") bit-by-bit to bit cell units through a first output (e.g. O₀) connected to the first memory bank (Bank0).

When a second memory bank (Bank1) is to be used as an operator, the IMC macro 200 may apply a 2-bit control signal "01" to the ENC block 255, which in turn may provide the same input data to bit cell units of the second memory bank (Bank1) via a second output (O₁) connected to the second memory bank (Bank1).

When a third memory bank (Bank2) is to be used as an operator, the IMC macro 200 may apply a control signal "10" to the ENC block 255, which may provide the same input data to bit cell units of the third memory bank (Bank2) via a third output (O₂) connected to the third memory bank (Bank2).

When a fourth memory bank (Bank3) is to be used as an operator, the IMC macro 200 may apply a control signal "11" to the ENC block 255, which outputs the input data to the fourth memory bank (Bank3) via a fourth output (O₃) connected to the fourth memory bank (Bank3).

In each case, whichever output (e.g., O₀) of the ENC block 255 is activated by the control signal to provide input data to the corresponding target/selected memory bank (e.g., Bank0), the ENC block 255 causes the other outputs to output "0" (e.g., O₁, O₂, and O₃) to the other (non-selected/non-target) memory banks. In this way, the outputs of the gate logic circuits of the IMC Macro depend only on the respective operation outputs of operators of the selected memory bank (as operated on the input bits and the bits in the bit cells of the selected memory bank).

FIG. 2C shows an example of a process in which an operation is performed in each memory bank as the input data 201 read by the input driver 250 is transferred to memory banks of the SRAM bit cell circuit 225. For example, as described above with reference to FIG. 2B, as the control signal "00" is applied to the ENC block 255, the ENC block 255 may sequentially provide the input data (e.g., "0011 0100 1010") bit-by-bit to bit cell units corresponding to the first memory bank (Bank0) in the IMC circuit 220. The ENC block 255 may provide "0" to the rest of the memory banks (e.g., Bank1, Bank2, and Bank3). Each of the bit cell units in the first memory bank (Bank0) may output a result of an operation (e.g., a multiplication operation) between values of the input data sequentially provided by the ENC block 255 and weight values stored in each of the bit cells 221-0 to 221-3, e.g., weight values w₀, w₁, w₂, and w₃. (containing arbitrary "0"s or "1"s).

For example, if the weight value w₀ stored in bit cell is "0", the gate logic circuit 227 connected to bit cell unit may output "0000 0000 0000", which is a result of bitwise multiplication operations between the input data (e.g., "0011 0100 1010") and w₀("0"). The weight contents of the memory banks other than Bank0 do not affect the outputs of the gate logic circuit 227 for these operations because those memory banks all receive "0" from the ENC block 255 during each of the multiplication operations. When the weight value w₀ is "1", the gate logic circuit 227 connected to bit cell unit may output "0011 0100 1011", which is a result of bitwise multiplication operations between the input data (e.g., "0011 0100 1010") and "1", as an operation result. Again, the weight contents of the memory banks other than Bank0 do not affect the outputs of the gate logic circuit 227 for these operations because those memory banks all receive "0" from the ENC block 255 during each of the multiplication operations.

FIG. 2D shows an example process of writing data (e.g., a weight value or an input value) read by the WBL driver 270 into memory banks (bit cells) (e.g., the first memory bank (Bank0)). The WWL driver 210 may select memory banks (and therefore bit cells thereof) for writing data into the IMC circuit 220. For example, when data is to be written in the first memory bank (Bank0), the WWL driver 210 may select the first memory bank (Bank0) by applying "1000" to WWL[3:0]. When data is to be written in the fourth memory bank (Bank3), the WWL driver 210 may select the fourth memory bank (bank 3) by applying "0001" to WWL[3:0]. In addition, the WBL driver 270 may provide data (e.g., a weight value) to be stored in the bit cells selected by the WWL driver 210. WBL[255:0] shown in FIG. 2A is a path for writing data to bit cells. In a 64 x 64 operator as illustrated in FIG. 2A, 256 bit-data may be simultaneously written to 64 rows having a weight of 4 bits (b) (for example w₀, w₁, w₂, w₃) each. Depending on the structure, 64-bit data may be simultaneously written in the column direction. When a 256-bit input (for storage) consecutively delivers data to each column (at one column per cycle), data of the entire operator may be recorded for a total of 64 cycles. When the WBL driver 270 performs a write operation, all "0" may be input to the RWL.

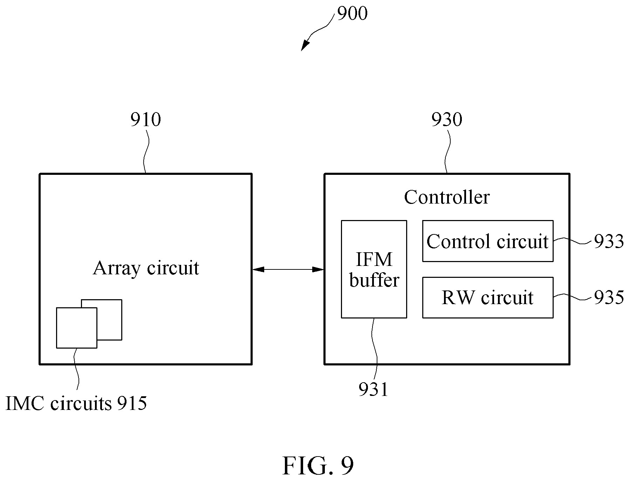

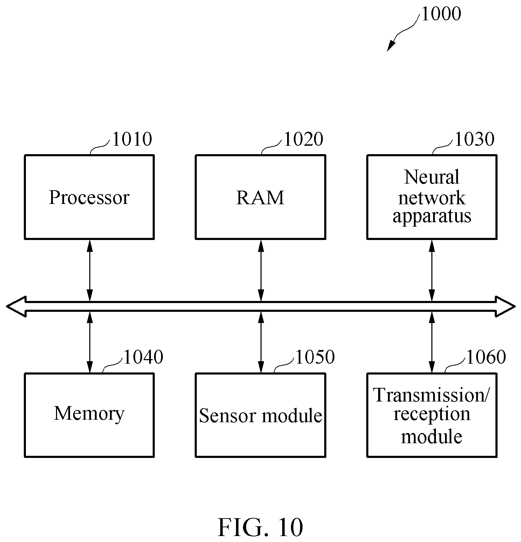

The input driver 250 may receive the input data 201 from an external module, such as, for example, a processor (e.g., a processor 1010 of FIG. 10), or the input data 201 may be read from an input feature map stored in an input feature map (IFM) buffer (e.g., an IFM buffer 931 of FIG. 9). The source of the input data 201 is not significant and any source may be used.

For example, as shown in FIG. 2A, when an input value of the input data 201 is multi-bit, the input driver 250 may sequentially transfer multi-bit values to the IMC circuit 220 for each bit position. For example, when the IMC macro 200 operates for a neural network operation, the input driver 250 may operate like an RWL driver. Hereinafter, the input driver 250 and the RWL driver will be understood to have the same general meaning.

The input driver 250 may apply input values received, for example, from M nodes of each layer of the neural network to read word lines (e.g., RWL₀, RWL₁ to RWL_{M-1}), generally, one layer after another. RWLₘ and IN[m] may correspond to the same node.

For example, an input value at an m-th node may be applied to RWLm, and the input value applied to the RWLm may be multi-bit or single-bit. In this example, m may be an integer greater than or equal to "0" and less than or equal to "M-1". For example, when the input value applied to the RWLm is multi-bit, the bit value for each bit position may be sequentially transferred to the IMC circuit 220 as described above. The input driver 250 may individually transfer the M input values received from the aforementioned nodes to M bit cells. As will be described later, since each of the M bit cells performs a multiplication operation with other bit cells in parallel, M multiplication operations may be performed in parallel for each bit line.

Alternatively, when the weight 203 is multi-bit, as many output lines as a number of bits for expressing the weight 203 may be grouped. The grouped output lines may be referred to as an "output line group". For example, when the weight 203 is X bits, X output lines may be grouped, and the IMC macro 200 may output a combined result, obtained by the grouped X output lines, of a product between the input value of the input data 201 and the weight 203 of the X bits. In this example, X may be greater than or equal to "2".

The SRAM bit cell circuit 225 may be composed of several bit cells to represent a multi-bit weight. An input (an input operand) may be simultaneously applied to each bit cell to be multiplied with the multi-bit weight (a weight operand). As an example, a first output line among X output lines grouped into one group may output a result of a multiplication between a weight bit value corresponding to a least significant bit (LSB) of a weight and an input bit value. Similarly, an x-th output line may output a result of multiplication between a weight bit value of an x-1-th bit position and an input bit value from the LSB. In this example, x may be greater than or equal to "2" and less than or equal to "X". The accumulator 240 may apply (i) a result of shifting the bit position corresponding to the output line of the same output line group by a predetermined bit (e.g., one bit) to (ii) a combined result output from the corresponding output line, and by accumulating the shifted values of the bit position, a final MAC operation result may be output. The accumulator 240 may be implemented as, for example, a shifter and an adder, or may be implemented by a separate accumulator, but is not limited thereto.

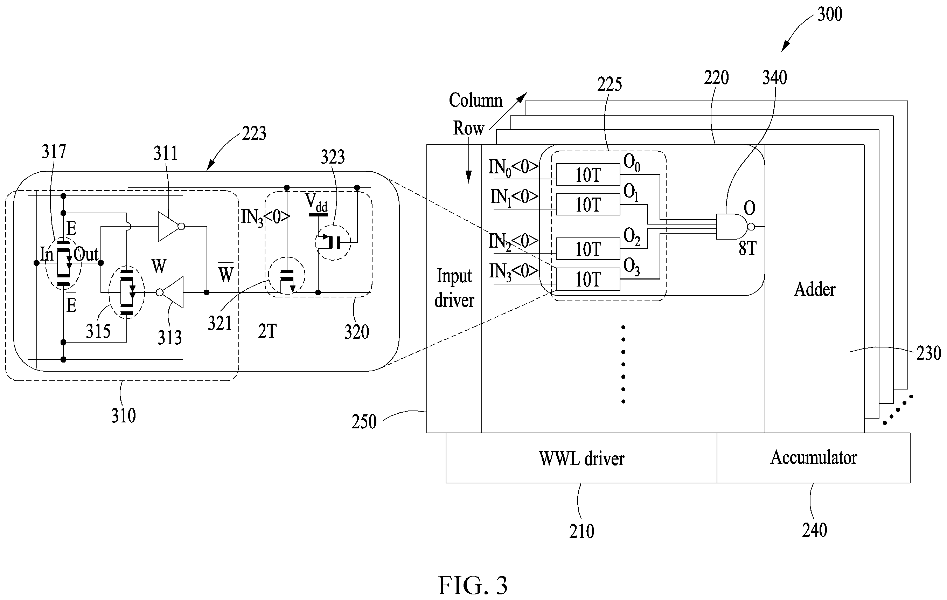

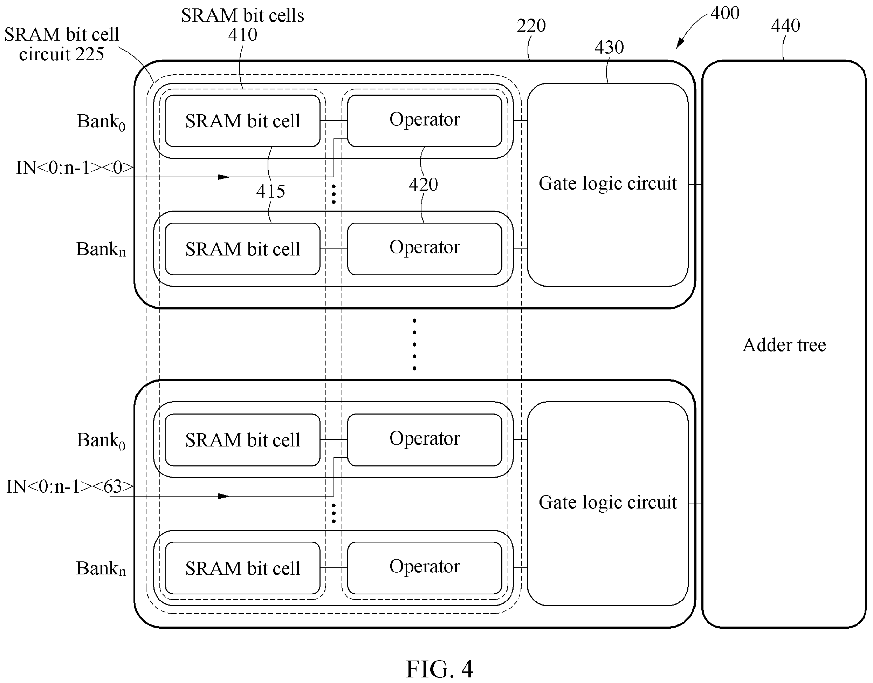

Each of the bit cells may store, for example, a value (e.g., a first value/operand) of the weight 203. The structure and operation of the IMC circuit 220 including a plurality of bit cells is described in more detail with reference to FIGS. 3 and 4.

The IMC circuit 220 may perform a multiplication operation between a value of the input data 201 received through the input driver 250 (i.e., an input operand) and the weight 203 stored in the bit cells (i.e., a stored operand). The IMC circuit 220 may output a signal corresponding to an operation result (e.g., a bit-wise multiplication operation result) corresponding to each of the bit cells through a structure in which the bit cell(s), operator(s), and gate logic circuit are connected. For example, as described with reference to FIG. 3, as an overall operation effect, the IMC circuit 220 may transfer, to the adder 230, a result value of an AND logic operation on signals corresponding to a result of a multiplication operation between a value (e.g., a first value/operand) of the weight 203 stored in each of the bit cells and an input value (e.g., a second value/operand) applied to the input signals of the bit cells corresponding to the memory banks through a word line.

The operator 222 may be in the form of, for example, a pass transistor logic in which the number of transistors is minimized.

The adder 230 may be connected to an output end of one or more IMC circuit(s) 220. The output end of the IMC circuit 220 may correspond to an output line. The output end of one or more IMC circuit(s) 220 may be connected to one output line. The adder 230 may add signals output from one or more IMC circuit(s) 220. The adder 230 may combine multiplication results of a plurality of IMC circuits 220 connected to the same output line. The adder 230 may be implemented as, for example, a full adder, a half adder, and/or a flip-flop. The adder 230 may be implemented as, for example, a digital adder such as an adder tree circuit, but is not limited thereto.

In addition, as described above, since the output result of the IMC circuit 220 is, in total effect, the result value of the AND logic operation, the adder 230 may be implemented by including an inverter for inverting the output result of each IMC circuit 220. Here, the adder 230 may combine the values obtained by inverting the output result of the IMC circuit 220. The adder 230 may transfer a result obtained by combining the multiplication result corresponding to each of the bit cells to the accumulator 240. An adder 230 may be disposed for each respective output line of the IMC circuit 220.

The accumulator 240 may store the output of the adder 230 that combines the multiplication operation results of the one or more IMC circuit 220, and the accumulator 240 may accumulate the combined results. The accumulator 240 may sum the multiplication results corresponding to each of the bit cells in the adder 230, and finally combine the summed results which are output as a MAC operation result (for example, through Q₀[13:0] to Q₆₃[13:0]).

For example, when the input driver 250 receives the input data 201 in multi-bit form, the WWL driver 210 may sequentially transfer the bit value of each bit position of the input data 201 to the IMC circuit 220 (for example, through write word lines WWL₀[3:0] to WWL₆₃[3:0]). Accordingly, the IMC circuit 220 may also output a multiplication operation result of the corresponding bit positions. The adder 230 may transfer a result of combining (adding) the multiplication operation result values of the corresponding bit positions to the accumulator 240.

The accumulator 240 may perform the combining by bit-shifting the combined result of the corresponding bit positions. The accumulator 240 may accumulate the multiplication operation results according to the bit positions, by combining a combined result of a next bit position with the corresponding bit-shifted combined result. As described later, since bit shifting is not required when the input driver 250 receives single-bit input data, the accumulator 240 may, alternatively, directly output the combined result of the adder 230, or store the combined result in an output register (not shown).

The output register may store a final multiplication operation result (e.g., a multiply-accumulate result) output from the accumulator 240. The accumulator 240 may also be referred to as a "shift-and-adder accumulator" in that it performs shift operations and sum operations as well as accumulation. The final multiply-accumulate result (e.g., MAC operation result) stored in the output register may be read by, for example, a processor (e.g., the processor 1010 of FIG. 10) of an electronic system, and used for other operations. For example, when the IMC macro 200 performs a MAC operation corresponding to several layers of a neural network at a time, the MAC operation result stored in the output register may be transferred to the WWL driver 210 for an operation to be performed on a next layer. The WWL driver 210 of the IMC macro 200 may perform a multiplication operation by selecting bit cell(s) to which a weight set corresponding to the next layer is set.

The WBL driver 270 may write data of one or more bit cells included in the IMC circuit 220. The WBL driver 270 may be briefly expressed by the term "write circuit". Hereinafter, "WBL driver" and "write circuit" are used interchangeably.

The data of one or more bit cells may include, for example, a value of the weight 203 to be multiplied by an input value in a MAC operation. The WBL driver 270 may access a bit cell of the IMC circuit 220 through a bit line (e.g., a WBL, WBLB). When the IMC circuit 220 includes a plurality of bit cells, the WBL driver 270 may access a bit cell connected to an activated word line among a plurality of word lines (RWL). The WBL driver 270 may set (write) a weight in the accessed bit cell, or read the weight set in the bit cell.

The memory controller 260 may control the WWL driver 210, one or more IMC circuit(s) 220, the accumulator 240 (for example, Accumulator<0> to Accumulator<63>), the adder 230, the input driver 250 and/or the output register.

The IMC macro 200 may be implemented as, for example, a neural network apparatus, an IMC circuit, a MAC arithmetic circuit and/or apparatus, but is not limited thereto. The IMC macro 200 may receive an input value through a word line, and output a signal that is a result of a multiplication between an input value and a weight stored in a 10T SRAM bit cell through a bit line.

FIG. 3 illustrates an example of an IMC circuit structure. Referring to FIG. 3, the IMC circuit 220 may include the SRAM bit cell circuit 225and a gate logic circuit 340, as shown in example 300.

The SRAM bit cell circuit 225 may include a plurality of bit cell units 223 corresponding to respective memory banks. A bit cell unit 223 may include one bit cell 310 and an operator 320 that outputs a signal corresponding to an operation result between an input bit and a value stored in the one bit cell 310. The operator 320 may correspond to the operator 222 described above with reference to FIG. 2A. Each bit cell 310 for storing a bit value may have its own respective operator 320.

The bit cell 310 may include a word line transistor composed of two inverters 311 and 313 and two transmission gates 315 and 317. The "transmission gate" may be a bidirectional switch in which an NMOS transistor and a PMOS transistor are connected in parallel, and may be controlled by an externally applied logic level/value. For example, when "1" is applied to the enable (E) terminals of the transmission gates 315 and 317, the transmission gates 315 and 317 may function as a "closed" switch. Alternatively, when "0" is applied to the E terminals of the transmission gates 315 and 317, the transmission gates 315 and 317 may function as an "opened" switch. Each of the inverters 311 and 313 and the transmission gates 315 and 317 may include two transistors.

The operator 320 may include a first transistor 321 and a second transistor 323. The first transistor 321 and the second transistor 323 may output a signal corresponding to a result of a bit-wise multiplication operation between a first value stored in the bit cell 310 (e.g., an internal/stored operand) and a second value applied as an input signal to the bit cell 310 through the input driver 250 (e.g., an external/inputted operand).

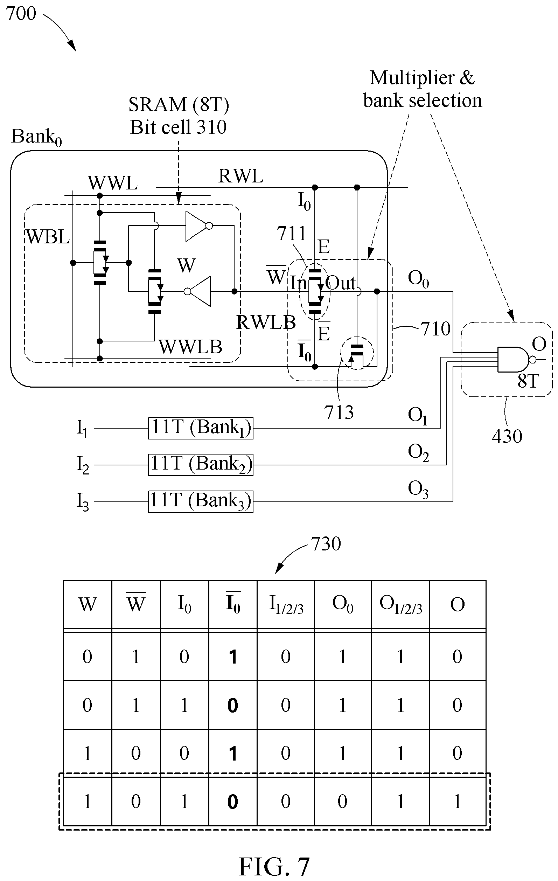

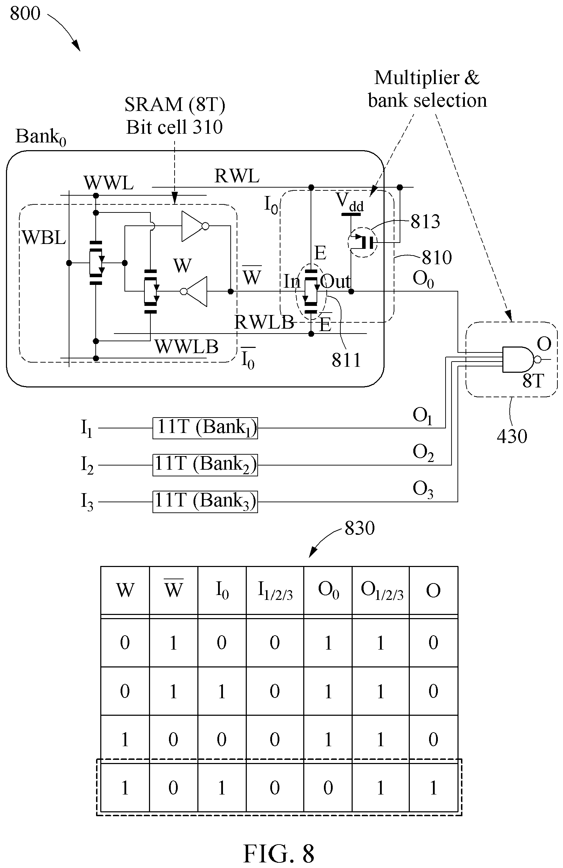

The operator 320 may consist of two transistors (2T) as illustrated in FIGS. 3, 5 and/or 6, or three transistors (3T) as illustrated in FIGS. 7 and/or 8.

For example, as illustrated in FIG. 3, when the operator 320 is composed of two transistors, the SRAM bit cell circuit 225 may be referred to as a "10T SRAM cell" structure or a "10T" structure in that the bit cell unit 223, which can both store a bit (bit cell 310) and perform a multiplication operation (operator 320) on its stored bit, is composed of 10 transistors (2 x 2 + 2 x 2 + 2 = 10).

The same input value may be applied to bit cell units in the same memory bank among the bit cell units of the SRAM bit cell circuit 225.

The "memory bank" may correspond to "one block" when an entire memory area is divided into multiple blocks. The memory bank has multiple pairs of the same address representing a memory area, and when 64-bit unit input/output occurs, may correspond to a logical group of one or more memory within a channel, which is a group that shares one data path. The memory bank may be used in pairs or sets. The memory bank may correspond to a memory group that shares the adder 230 such as, for example, an adder tree. The bit cells 310 may correspond to, for example, four memory banks.

Each of the operators 320 may include the first and second transistors 321 and 323 that output a signal corresponding to a result of a bit-wise multiplication operation between a first value (a stored/internal operand) stored in each of the bit cells corresponding to a corresponding memory bank among the plurality of memory banks and a second value (an inputted/external operand) applied as an input signal of the corresponding memory bank. Each of the operators 320 may correspond to each of the respective bit cells 310. That is, as noted above, each bit cell 310 may have its own respective operator 320.

The gate logic circuit 340 may transfer, to the adder 230, an operation result corresponding to each of the bit cells belonging to a target memory bank, among the memory banks, for a MAC operation. The gate logic circuit 340 may transfer the operation result corresponding to each of the bit cells included in the corresponding memory bank to the adder 230 according to which of the operators 320 the second value is applied to (the other/non-selected operators, as discussed below, may output "0"). The gate logic circuit 340 may include, for example, any one of a NAND gate, a NOR gate, an XOR gate, an XNOR gate, an AND gate, and an OR gate, but is not limited thereto. For example, when the gate logic circuit 340 is a NOR gate, an XOR gate, an XNOR gate, an AND gate, or an OR gate, a structure of the bit cell unit 223 (e.g., the operator 320) may be correspondingly changed to enable the gate logic circuit 340 and operators 320, in their combined operation, to output (from the gate logic circuit 340) a multiplication result (or possibly an inverted multiplication result).

A size of the layout and complexity of the routing of the SRAM bit cell circuit 225 in the IMC circuit 220 may significantly affect over power efficiency and/or area efficiency of an encompassing SRAM IMC circuit.

In addition, an area efficiency D_{M} of a memory may be estimated by Equation 3. ${D}_{M} \left[Mb/{mm}^{2}\right] = \frac{ROW ⋅ COL ⋅ WE ⋅ Bank}{Area}$ Equation 3

WE corresponds to a memory capacity for multi-bit data. For example, WE may be "8" to represent 8 bits, and WE may be "4" to represent 4 bits.

Areal density may be improved by decreasing an area of the memory or increasing the number of memory banks according to Equation 3. The area of the memory may correspond to, for example, an area occupied by bit cells, the adder 230 and/or peripheral control lines.

Similarly, by reducing the number of transistor(s) included in the IMC circuit 220, decreasing the number of transistor(s) constituting the memory cell, and/or increasing the number of memory banks, the area of the IMC circuit 220 may be reduced.

For example, by configuring the bit cells of an SRAM to be organized into memory banks and by transferring an operation result corresponding to a target memory bank among the memory banks by the operator 320 and the gate logic circuit 340 configured with a small number (e.g., two or three) transistors to the adder 230, a lower-voltage write operation may be provided by reducing the number of control lines of the IMC circuit, while the area efficiency of the IMC circuit may be improved. In this example, the term "target memory bank" may refer to a corresponding memory bank when an operation result corresponding to each of the bit cells belonging to the corresponding memory bank (among the memory banks) is used for a MAC operation.

Configurations of the bit cells of the IMC circuit 220 into memory banks is described in more detail with reference to FIG. 4.

FIG. 4 illustrates an example IMC circuit. An example 400 of a structure of an IMC circuit may include the SRAM bit cell circuit 225 including SRAM bit cells 415 (e.g., the bit cells 221 of FIG. 2) corresponding to a plurality of memory banks (e.g., Bank₀ to Bankₙ) and operators 420 (e.g., the operators 222 of FIG. 2) respectively corresponding to the SRAM bit cells 415, and an adder 440 (e.g., an adder tree).

The same word line (e.g., IN<0: n-1> <0>, ..., IN<0: n-1> <63>) may be applied. Here, n may be 64 but is not limited thereto.

The SRAM bit cell circuit 225 of the IMC circuit 220 may include the operators 420 that output a signal corresponding to a result of an operation between values of an external input signal input to the operators 420and values stored in the SRAM bit cells 415. The IMC circuit 220 may adjust an input of the operators 420 for performing the operation so that the operation result corresponding to each of the SRAM bit cells 410 belonging to a target memory bank for a MAC operation may be transferred to the adder 440 (i.e., non-target operation results do not contribute to the operation result).

An output of each of the operators 420 may be passed through a logic operation (e.g., a NAND logic operation) of the gate logic circuit 430 and an output thereof is transferred to the adder 440, e.g., an adder tree.

The IMC circuit 220 may allow the operation result corresponding to the bit cells belonging to the target memory bank for the MAC operation to be "0" or "1" (depending on the values in the bit cells of the target memory bank and the input bit values), and the operation result corresponding to the bit cells belonging to remaining (non-target) memory banks to be "0". By doing so, the operation result corresponding to the target memory bank may be used for the MAC operation and the non-target memory banks do not affect the operation result.

For example, by configuring the SRAM bit cells 415 into a plurality of memory banks, the number of control lines for controlling the operator(s) 420 may be reduced, and thereby the implementation area of the IMC circuit 220 may be reduced, and area efficiency of the IMC circuit 220 may be improved.

In addition, by reducing the number of transistors for a multiplication operation by the operator(s) 420, the total number of transistors constituting the IMC circuit 220 may be reduced.

The IMC circuit 220 may partially isolate power applied to each of the SRAM bit cell circuit 225, the gate logic circuit 430, and the adder 440, such that a different voltage may be applied to each of the SRAM bit cell circuit 225, the gate logic circuit 430, and/or the adder 440.

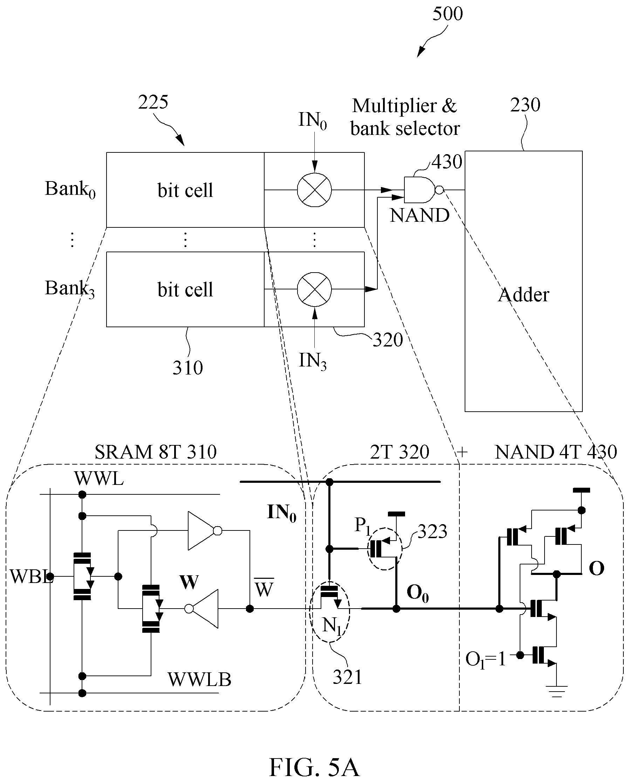

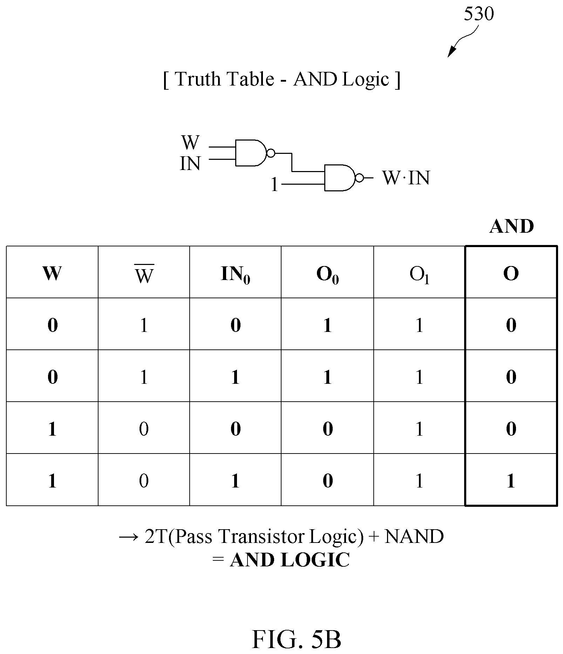

FIGS. 5A and 5B illustrate an example operation when an operator of an IMC circuit is composed of two transistors. Referring to FIG. 5A, an example 500 structure of an IMC circuit including the SRAM bit cell circuit 225 and the gate logic circuit 430 (e.g., a NAND gate) is illustrated.

The SRAM bit cell circuit 225 may be a multiplication cell implemented by, for each bit cell unit thereof, combining the bit cell 310 composed of 8 transistors (8T) with the operator 320 composed of 2 transistors (2T) and the gate logic circuit 430. The SRAM bit cell circuit 225 may include, for example, four bit cells 310 respectively corresponding to four memory banks (Bank₀, Bank₁, Bank₂, Bank₃) grouped into a word line corresponding to each of four bit-input signals IN₀, IN₁, IN₂, IN₃ and four operators 320 respectively corresponding to each of the bit cells 310.

The operator 320 may be configured as a 2T circuit including the first transistor (N₁) 321 and the second transistor (P₁) 323. The first transistor 321 may correspond to, for example, an NMOS transistor, but is not limited thereto. Also, the second transistor 323 may correspond to a PMOS transistor, but is not limited thereto.

For example, a second value/operand (e.g., input signal IN₀) corresponding to an input signal of a target memory bank (e.g., memory bank 0 (Bank₀)) may be applied to a first gate terminal of the first transistor 321 and a second gate terminal of the second transistor 323 through a RWL of the bit cell 310 corresponding to memory bank 0. An inverted weight *W̅* of a weight W stored in the bit cell 310 belonging to memory bank 0, which is the target memory bank, may be applied to a drain terminal of the first transistor 321. A source terminal of the first transistor 321 may be connected to an input terminal of the gate logic circuit 430 via a drain terminal of the second transistor 323.

An output value of the first transistor 321 passing through the first gate terminal of the first transistor 321 may be connected to an output value of the second transistor 323 passing through the second gate terminal of the second transistor 323, and output as a signal (e.g., O₁) corresponding to a bit-wise multiplication operation result.

Referring to FIG. 5B, following is an explanation of a truth table 530, which represents an operation of the SRAM bit cell circuit 225 when memory bank 0 (Bank₀) is a target memory bank in the IMC circuit shown in FIG. 5A. The column headings in truth table 530 correspond to same points/lines in the circuit of FIG. 5A.

In one case, the input signal IN₀ corresponding to memory bank 0 (Bank₀) is "1", and input signals IN₁, IN₂, IN₃ corresponding to each of memory bank 1 (Bank₁), memory bank 2 (Bank₂), and memory bank 3 (Bank₃) are each "0". In addition, when the weight W stored in the bit cell 310 of memory bank 0 (Bank₀) is "1", the inverted weight *W̅* is "0".

In this case, when the input signal IN₀ is "1" and is applied to the gate terminal of the first transistor 321 (which is an NMOS transistor of memory bank 0 (Bank₀)), a potential difference is generated between the gate terminal and the source terminal of the first transistor 321 such that a channel is formed and the first transistor 321 becomes "ON". When the first transistor 321 is "ON", the inverted weight *W̅* = "0" connected to the drain terminal of the first transistor 321 is output as an output value O₀ of the operator 320 of the bit cell 310 corresponding to memory bank 0 (Bank₀). In addition, when the input signal IN₀ is "1" and is applied to the gate terminal of the second transistor 323 (which is a PMOS transistor of memory bank 0 (Bank₀)), a potential difference is not generated between the second gate terminal and the source terminal of the second transistor 323 such that a channel is not formed and the second transistor 323 becomes "OFF".

In this case, when the input signals IN₁, IN₂, IN₃ corresponding to each of non-target memory banks 1, 2, and 3 are "0", according to the method described above, output value O₁ of the operators 320 of the bit cells corresponding to memory banks 1, 2, and 3 are "1". Thus, the output of the NAND gate 430 will depend only on the output O₀. Since the output value O₀ of the operator 320 of the bit cell 310 corresponding to memory bank 0 (among the output values of the bit cells corresponding to the respective memory banks) is "0", an output value O of the NAND gate 430 is "1".

In another case, the input signal IN₀ corresponding to memory bank 0 is "0", and input signals IN₁, IN₂, IN₃ corresponding memory banks 1, 2, and 3 are "0". In addition, when the weight W stored in the bit cell 310 of memory bank 0 is "0", the inverted weight *W̅* may be "1". When the input signal IN₀ which is "0" is applied to the gate terminal of the first transistor 321 (which is an NMOS transistor of memory bank 0 (Bank₀)), since a potential difference does not occur between the gate terminal and the source terminal of the first transistor 321, a channel is not formed and the first transistor 321 becomes "OFF". In addition, when the input signal IN₀ which is "0" is applied to the gate terminal of the second transistor 323 (which is a PMOS transistor of memory bank 0 (Bank₀)), a channel is formed due to a potential difference generated between the second gate terminal and the source terminal of the second transistor 323 such that the second transistor 323 becomes "ON". When the second transistor 323 is "ON", "1" corresponding to a Vdd voltage applied to the source terminal of the second transistor 323 is output as the output value O₀ of the operator 320 of the bit cell 310 corresponding to memory bank 0.

When the input signals IN₁, IN₂, IN₃ corresponding to each of memory banks 1, 2, and 3 are "0", according to the method described above, output value O₁ of the bit cells corresponding to memory banks 1, 2, and 3 may be "1". When the output values of the bit cells corresponding to the respective memory banks are all "1", the output value O of the NAND gate 430 may be "0", and as a result, the same result as performing the AND logic operation may be obtained.

As illustrated in FIG. 5A, a multiplication operation between the input signal IN₀ applied to the operator 320 corresponding to memory bank 0 grouped into the RWL corresponding to the input signal IN₀ and the weight W stored in the bit cell 310 may be performed through a pass transistor logic structure using the inverted weight *W̅* of the weight W stored in the bit cell 310 and the input signal IN₀ as inputs.

Pass transistor logic may be used to reduce transistors for implementing logic by driving a gate terminal, a source terminal, and a drain terminal using a primary input. In complementary CMOS logic, the primary input may drive the gate terminal. The primary input may correspond to, for example, an input, an inverting input, VDD, and GND.

As described above, FIG. 5A illustrates an example in which an AND function is implemented by the IMC circuit using an NMOS pass transistor. In the NMOS pass transistor, when a gate input is high, a left NMOS transistor, that is, the first transistor 321 may be turned on, and a source input may be copied to the output. On the other hand, when the gate input of the NMOS pass transistor is low, a right NMOS pass transistor, that is, the second transistor 323 may be turned on, and may transfer "0" to the output.

The truth table 530 of FIG. 5B shows a truth table of the AND gate for the above-described operation.

An input signal "1" is applied through the RWL of the bit cells corresponding to the memory bank used for the MAC operation, and the operation results of the bit cells belonging to the corresponding memory bank are transferred to the adder (e.g., the adder 440 of FIG. 4) so that the corresponding memory bank is processed as if it were the only memory bank effectively selected. On the other hand, an input signal "0" is applied to the RWL of the bit cells corresponding to the memory bank that is not used for the MAC operation, and the operation results of the bit cells belonging to the corresponding memory bank are not transferred so that the corresponding memory bank is processed as if it were not selected.

For example, a bit-wise multiplication operation is performed using the gate logic circuit 430 (e.g., a NAND gate) composed of two transistors even without a separate RWL control signal for reading the input signal IN₀. Therefore, the number of control lines of an interface may be reduced to 4 lines per bit cell 310 (e.g., a WBL, WWL, write bit line inverted (WWBL), and RWL).

Thus, the total number of transistors constituting the IMC circuit may be 4 banks x (SRAM bit cell (8T) + operator (2T)) + gate logic circuit (8T) = 4 X 10T + 8T = 48T, and the total number of control lines may be 4 banks X 4 = 16.

As illustrated in FIGS. 5A and 5B, the output value O₀ of the multiplication operation of the bit cell 310 corresponding to memory bank 0 grouped into the word line corresponding to the input signal IN₀ is transferred to the NAND gate 430 together with the output value O₁ of the multiplication operation of other bit cells. The NAND gate 430 may transfer a result O of performing a NAND logic operation on the output values O₀ and O₁ of the four bit cells (as shown in the truth table 530) to the adder 230 as an input thereof, and thereby allow the MAC operation to be performed.

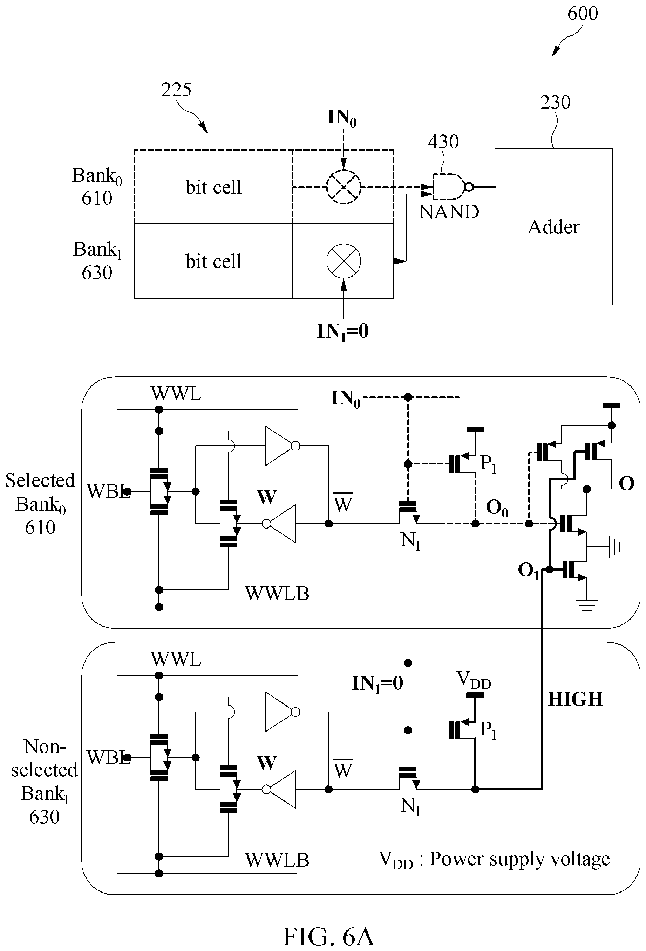

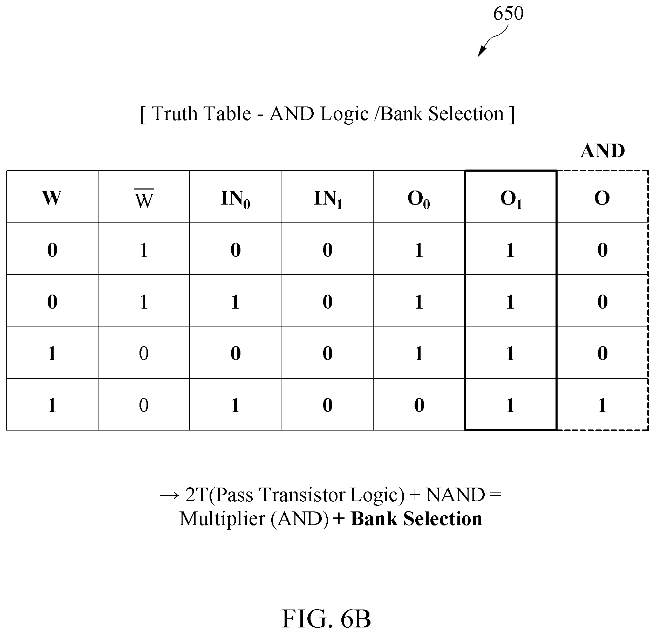

FIGS. 6A and 6B illustrate an example of a method of an IMC circuit selecting a memory bank. Referring to FIG. 6A, an example 600 is shown in which memory bank 0 (Bank₀) 610 of an IMC circuit is selected as a target memory bank, and memory bank 1 (Bank₁) 630 of the IMC circuit is not selected as the target memory bank. FIG. 6B, shows a truth table 650 with input and output values of the IMC circuit of FIG. 6A. In FIG. 6A, V_{DD} may refer to a power supply voltage.

As illustrated in FIG. 6A, when a weight W stored in a bit cell of memory bank 0 610 (which is selected as a target memory bank) is "0", and a value applied to input signal IN₀ of memory bank 0 610 through the word line is "1", a value of output O₀ corresponding to memory bank 0 is "1". When the value of output O₀ of the bit cell corresponding to memory bank 0 (which is just one of the output values O_{0,} O₁ of the bit cells inputted to the NAND gate) is "1", an output value O of a NAND gate becomes "0", so a MAC operation in the adder 230 is not affected.

In other words, when the corresponding bit cell units of the other memory banks (memory bank 1, memory bank 2, and memory bank 3) have inputs of "0", their respective bit cell operators all output "1" to the NAND gate. Therefore, the output of the NAND gate is determined only by the output of memory bank 0 610's bit cell units; the weights of the other memory banks (e.g., memory bank 1, memory bank 2, and memory bank 3) cannot influence the output of the NAND gate. Put yet another way, because only the memory bank 0's bit cell unit has an input of "1", its bit cell unit becomes the only bit cell unit, among the four bit cell units, whose weight W can influence the output of the NAND gate.

On the other hand, when a weight W stored in the bit cell corresponding to memory bank 0 610 is "1", and a value applied to input signal IN₀ of memory bank 0 through the word line is "1", a value of output O₀ corresponding to memory bank 0 is "0". As noted above, the weights W of any bit cells of respective input memory banks that receive an input of "0" do not influence the output of the logic/NAND gate (i.e., only the weight W of a bit cell receiving an input of "1" contributes to the operation). When the value of output O₀ of the bit cell unit corresponding to memory bank 0 (which is just one of the output values O_{0,} O₁ of the bit cells corresponding to each memory bank fed to the NAND gate), is "0", the output value O of the NAND gate becomes "1", so the MAC operation in the adder 230 may be affected. As described above, since the output corresponding to the memory bank to which the input signal "1" is applied may affect the MAC operation in the adder, for example, the input signal may be applied through the RWL without a separate control signal, thereby allowing the target memory bank to act as if it were selected for the MAC operation.

In another example, as illustrated in example 600, when a weight W stored in a bit cell corresponding to memory bank 1 is "1", and a value applied to input signal IN, of memory bank 1 through the word line is "0", a value of output O₁ corresponding to memory bank 1 may be "1" (i.e., having a high level HIGH), so the MAC operation in the adder 230 may not be affected via an output of the NAND gate.

To summarize, among a group of bit cells of respective memory banks, each bit cell has its own respective operator (e.g., a bit multiplier). "Deactivation" or "control" input signals ("0") may be supplied to bit cell units of memory banks that are not a target of an operation. Such signals are not actual input data signals but rather are provided by memory bank targeting/selection circuitry. An actual data signal is supplied to the bit cell unit of the memory bank that is the current operation target. If the data input is "0", then the operation result/output is "0", however, if the data input is "1", then the operation result depends on the value (e.g., a weight bit) stored in the target bit cell. If that value is "1", then the operation result is "1". If that value is "0", then the operation result is "0".

FIG. 7 illustrates an example of an operation when an operator of an IMC circuit is composed of three transistors. Referring to FIG. 7, an example 700 of a structure of an IMC circuit is shown as including: an SRAM bit cell circuit including bit cells 310 corresponding to each of four memory banks grouped into a word line corresponding to each of input signals I₀, I₁, I₂, I₃ and an operator 710 corresponding to each of the bit cells; and a gate logic circuit 430 (e.g., a NAND gate).

The operator 710 may be configured as a 3T circuit including a transmission gate 711 and a third transistor 713. The third transistor 713 may correspond to, for example, a PMOS transistor, but is not limited thereto.

A second value (e.g., input signal I₀) corresponding to an input signal of a target memory bank (e.g., memory bank 0) may be applied to an E terminal of the transmission gate 711 and a gate terminal ("third gate terminal") of the third transistor 713 through a RWL of a bit cell corresponding to memory bank 0.

In addition, an inverted weight *W̅* of a weight W stored in the bit cell 310 belonging to memory bank 0, which is the target memory bank, may be applied to an input In of the transmission gate 711. An inverted input *I̅₀* of the bit cell 310 may be connected to an enable bar E̅ of the transmission gate 711 and a source terminal of the third transistor 713.

Each of an output value of the transmission gate 711 and an output value of the third transistor 713 passing through the third gate terminal of the third transistor 713 may be connected to an input of the NAND gate 430 and output as a signal corresponding to a bit-wise multiplication operation result.

For example, as illustrated in table 730, the weight W stored in the bit cell 310 of memory bank 0 may be "1", the input signal I₀ corresponding to memory bank 0 may be "1", and input signals I₁, I₂, I₃ corresponding to each of memory bank 1, memory bank 2, and memory bank 3 may be "0".

In this case, when the input signal I₀ "1" is applied to the E terminal of the transmission gate 711, the transmission gate 711 serves as a "closed" switch, so a value of the inverted weight *W̅* connected to an input terminal of the transmission gate 711, which is "0", is output to an output Out terminal of the transmission gate 711. In addition, as the input signal I₀ = "1" is applied to the gate terminal of the third transistor 713, the inverted input *I̅₀* = "0" connected to the source terminal of the third transistor 713 is output as an output value of the third transistor 713.

Since the output value ("0") output from the transmission gate 711 and the output value ("0") of the third transistor 713 are both "0", the output value (O₀) of the bit cell 310 corresponding to memory bank 0 may be output as "0". Since the output value O₀ of the operator 710 corresponding to memory bank 0 (among the output values of the bit cells corresponding to the respective memory banks) is "0", an output value O of the NAND gate 430 is "1".

In the IMC circuit structure shown in FIG. 7, when an input signal is "1", data value *W̅* stored in the bit cell is transferred through the transmission gate 711 operating as a switch, so the IMC circuit structure shown in FIG. 7 may be able to operate at a lower voltage compared to the IMC circuit structure shown in FIG. 5.

In addition, the total number of transistors constituting a unit bit cell of the IMC circuit shown in FIG. 7 may be 4 banks x (SRAM bit cell 8T + operator 3T) + gate logic circuit 430 (8T NAND gate) = 4 X 11T + 8T = 52T, and the total number of control lines may be 4 banks X 5 (e.g., WBL, WWL, WWLB, RWL, read word line inverted (RWLB)) = 20.

FIG. 8 illustrates another example of an operation when an operator of an IMC circuit is composed of three transistors. Referring to FIG. 8, an example 800 of a structure of an IMC circuit includes: an SRAM bit cell circuit including bit cells 310 corresponding to each of four respective memory banks grouped into a word line corresponding to each of input signals Iₒ, I₁, I₂, I₃ and an operator 810 corresponding to each of the bit cells 310; and a gate logic circuit 430 is illustrated.

The operator 810 may be configured as a 3T circuit including a transmission gate 811 and a fourth transistor 813 connected in parallel with an NMOS transistor and a PMOS transistor. The transmission gate 811 may be switched on or off by an input I applied to a gate of each transistor. The fourth transistor 813 may correspond to, for example, a PMOS transistor, but is not limited thereto.

A second value (e.g., input signal I₀) corresponding to an input signal of a target memory bank (e.g., memory bank 0) may be applied to an E terminal of the transmission gate 811 and a gate terminal ("fourth gate terminal") of the fourth transistor 813 through a RWL of a bit cell corresponding to memory bank 0.

In addition, an inverted weight *W̅* of a weight W stored in the bit cell 310 belonging to memory bank 0, which is the target memory bank, may be applied to an input In of the transmission gate 811. An inverted input *I̅₀* of the bit cell 310 may be connected to an enable bar E̅ of the transmission gate 811.

A source terminal of the fourth transistor 813 may be connected to Vdd, and a drain terminal of the fourth transistor 813 may be connected to the inverted weight *W̅* of the weight W stored in the bit cell 310.

Each of an output value of the transmission gate 811 and an output value of the fourth transistor 813 passing through the fourth gate terminal of the fourth transistor 813 may be connected to an input of the NAND gate 430 and output as a signal corresponding to a bit-wise multiplication operation result.

For example, as illustrated in table 830, the weight W stored in the bit cell 310 of memory bank 0 may be "1", the input signal I₀ corresponding to memory bank 0 may be "1", and input signals I₁, I₂, I₃ corresponding to each of memory bank 1, memory bank 2, and memory bank 3 may be "0".

In this example, when the input signal I₀ "1" is applied to the E terminal of the transmission gate 811, the transmission gate 811 serves as a "closed" switch, so a value of the inverted weight *W̅* connected to an input terminal of the transmission gate 811, which is "0", may be output to an output (Out) terminal of the transmission gate 811. In addition, when the input signal I₀ = "1" is applied to the gate terminal of the fourth transistor 813, a potential difference may not be generated between the gate terminal ("fourth gate terminal") and the source terminal of the fourth transistor 813 such that a channel is not formed and the fourth transistor 813 becomes "OFF". Accordingly, an output value of the fourth transistor 813 may be "0".

Since the output value ("0") output from the transmission gate 811 and the output value ("0") of the fourth transistor 813 are both "0", the output value (O₀) of the operator 810 of the bit cell 310 corresponding to memory bank 0 is output as "0". Since the output value O₀ of the operator 810 of the bit cell 310 corresponding to memory bank 0 (among the output values of the bit cells corresponding to the respective memory banks) is "0", an output value O of the NAND gate 430 is "1", which is a multiplication result between only the weight W ("1") and the only data input (also "1").

FIG. 9 illustrates an example of a neural network apparatus including an IMC circuit. Referring to FIG. 9, a neural network apparatus 900 may include an array circuit 910 and a controller 930.

The array circuit 910 may include a plurality of IMC circuits 915. Each of the IMC circuits 915 may be provided with operators corresponding to each of the bit cells, and the operators may be configured to output a signal corresponding to a result of an operation between a first value stored in each of the bit cells corresponding to a corresponding memory bank among a plurality of memory banks and a second value. Each of the IMC circuits 915 may include an SRAM bit cell circuit(including operators) and a gate logic circuit. Each of the IMC circuits 915 may correspond to any of the IMC circuits described above with reference to FIGS. 2 to 8.

The SRAM bit cell circuit may include bit cells organized into memory banks, and the bit cells may be grouped into word lines of the SRAM for each memory bank.

The operators may output signals corresponding to operation results of the bit cells respectively corresponding to the operators. The operators may include a respective plurality of transistors that output a signal corresponding to a result of a bit-wise multiplication operation between (i) a first value stored in the corresponding bit cell (corresponding to a memory bank among the plurality of memory banks) and (ii) a second value applied as an input signal of the corresponding memory bank through the word line. Each of the operators may be configured as a 2T circuit or a 3T circuit.

For example, each of the operators may be configured as a 2T circuit including a first transistor and a second transistor. In this example, the second value corresponding to the input signal of the corresponding memory bank may be applied to the first gate terminal of the first transistor and the second gate terminal of the second transistor. In addition, an output value of the first transistor passing through the first gate terminal may be connected to an output value of the second transistor passing through the second gate terminal, and thereby be output as the signal corresponding to the bit-wise multiplication operation result.

As another example, each of the operators may be configured as a 3T circuit including a transmission gate and a third transistor. In this example, the second value corresponding to the input signal of the corresponding memory bank may be applied to an E terminal of the transmission gate and a third gate terminal of the third transistor. An output value of the transmission gate may be connected to an output value of the third transistor passing through the third gate terminal to be output as a signal corresponding to the bit-wise multiplication operation result.

The gate logic circuit (the logic gates) may transfer, to an adder, an operation result corresponding to each of the bit cells belonging to a target memory bank for a MAC operation. Each of the IMC circuits 915 may correspond to any of the IMC circuits described above with reference to FIGS. 3 to 8.

The controller 930 may input second values corresponding to an input signal of the neural network apparatus 900 to each of the IMC circuits 915 according to a clock signal, and control each of the IMC circuits 915.

The controller 930 may include, for example, any one of, or any combination of, an input feature map (IFM) buffer 931 that stores an input feature map including second values, a control circuit 933 that controls which of the second values are applied to which of the IMC circuits 915, and a read write (RW) circuit 935 that reads or writes the first values.

The control circuit 933 may control whether the second values are applied to the plurality of transistors included in the operators such that the gate logic circuit may transfer, to the adder, the operation result corresponding to each of the bit cells belonging to the corresponding memory bank.

Although IMC devices are described above with reference to neural network data such as weights, input data/maps, and the like, the IMC devices are not limited to any particular type of data. That is to say, the circuits and devices are novel and beneficial regardless of the types of data that they are used to process. Processing of neural network data is only one of many potential applications.

FIG. 10 illustrates an example of an electronic system including a neural network apparatus. Referring to FIG. 10, an electronic system 1000 may analyze input data based on an artificial neural network (e.g., the neural network 110 of FIG. 1) and extract valid information, determine a situation based on the extracted information, or control components of an electronic device (e.g., in real time or on-the-fly) to which the electronic system 1000 is installed. For example, the electronic system 1000 may be used to control or supplement operations of a drone, a robot apparatus such as an advanced drivers assistance system (ADAS), a smart TV, a smartphone, a medical device, a mobile device, a video display device, a measurement device, and an Internet of things (IoT) device, and in addition thereto, may be installed in various types of electronic devices.

The electronic system 1000 may include a processor 1010, a random access memory (RAM) 1020, a neural network apparatus 1030, a memory 1040, a sensor module 1050, and a transmission/reception module 1060. The electronic system 1000 may further include an input/output module, a security module, a power control apparatus, and the like. Some of the hardware components of the electronic system 1000 may be mounted on at least one semiconductor chip.

The processor 1010 may control the overall operation of the electronic system 1000. The processor 1010 may include one processor core (Single Core) or a plurality of processor cores (Multi-Core). The processor 1010 may process or execute programs and/or data stored in the memory 1040. The processor 1010 may control a function of the neural network apparatus 1030 by executing programs stored in the memory 1040 . The processor 1010 may be implemented as a central processing unit (CPU), a graphics processing unit (GPU), an application processor (AP), and the like.

The RAM 1020 may temporarily store programs, data, or instructions. For example, the programs and/or the data stored in the memory 1040 may be temporarily stored in the RAM 1020 according to the control of the processor 1010 or a booting code. The RAM 1020 may be implemented as, for example, a memory such as a dynamic RAM (DRAM) or an SRAM.

The neural network apparatus 1030 may perform an operation of the neural network based on received input data, and may generate various information signals based on a result of the operation. The neural network may be, for example, a convolution neural network (CNN), a recurrent neural network (RNN), fuzzy neural networks (FNN), a deep belief network, or a restricted Boltzman machine, and the like, but is not limited thereto. The neural network apparatus 1030 may be, for example, a hardware accelerator dedicated to the neural network and/or an apparatus including the same, or may correspond to the neural network apparatus 900 described above with reference to FIG. 9.

The neural network apparatus 1030 may control SRAM bit cell circuits of an IMC circuit to share and/or process the same input data, and select at least a portion of operation results output from the SRAM bit cell circuits.

The information signal may include, for example, one of various types of recognition signals, such as a speech recognition signal, an object recognition signal, a video recognition signal, and a biological information recognition signal. For example, the neural network apparatus 1030 may receive, as input data, frame data included in a video stream and may generate a recognition signal about an object included in an image represented by the frame data from the frame data. The neural network apparatus 1030 may receive various types of input data and may generate a recognition signal according to the input data based on a type or a function of an electronic device to which the electronic system 1000 is installed.

The memory 1040 refers to a storage configured to store data and may store an OS, various types of programs, and various types of data. Depending on examples, the memory 1040 may store intermediate results generated in a process of performing an operation of the neural network apparatus 1030.

The memory 1040 may include any one or any combination of a volatile memory and a non-volatile memory (excluding signals per se). Non-volatile memory may include, for example, a read only memory (ROM), programmable read only memory (PROM), erasable programmable read only memory (EPROM), electrically erasable programmable read only memory (EEPROM), and a flash memory, but is not necessarily limited thereto. Volatile memory may include, for example, a DRAM, SRAM, synchronous DRAM (SDRAM), phase change memory RAM (PRAM), magneto-resistive RAM (MRAM), resistive RAM (RRAM), and/or ferroelectric RAM (FRAM), but is not necessarily limited thereto. Depending on examples, the memory 1040 may include any one or any combination of a hard disk drive (HDD), a solid state drive (SSD), a compact flash (CF) card, secure digital (SD) card, micro-SD, Mini-SD, extreme digital (Xd) picture card, and a memory stick.

The sensor module 1050 may collect information around the electronic device on which the electronic system 1000 is installed. The sensor module 1050 may sense or receive a signal (e.g., an image signal, a speech signal, a magnetic signal, a bio signal, a touch signal, and the like) from the outside of the electronic system 1000 and convert the sensed or received signal into data. The sensor module 1050 may include any one or any combination of various sensing devices such as a microphone, an imaging device, an image sensor, a light detection and ranging (LIDAR) sensor, an ultrasonic sensor, an infrared sensor, a biosensor, and a touch sensor.

The sensor module 1050 may provide the converted data to the neural network apparatus 1030 as input data. For example, the sensor module 1050 may include an image sensor, generate a video stream by capturing an external environment of the electronic system 1000, and provide successive data frames of the video stream as input data to the neural network apparatus 1030. However, the example is not limited thereto, and the sensor module 1050 may provide various types of data to the neural network apparatus 1030.

The transmission/reception module 1060 may include various types of wired or wireless interfaces capable of communicating with an external apparatus. For example, the transmission/reception module 1060 may include a wired local area network (LAN), a wireless local area network (WLAN) such as wireless fidelity (Wi-Fi), a wireless personal area network (WPAN) such as Bluetooth, a wireless universal serial bus (USB), ZigBee, near field communication (NFC), radio-frequency identification (RFID), power line communication (PLC), a communication interface accessible to a mobile cellular network, such as 3rd Generation (3G), 4th Generation (4G), and Long Term Evolution (LTE), and the like.

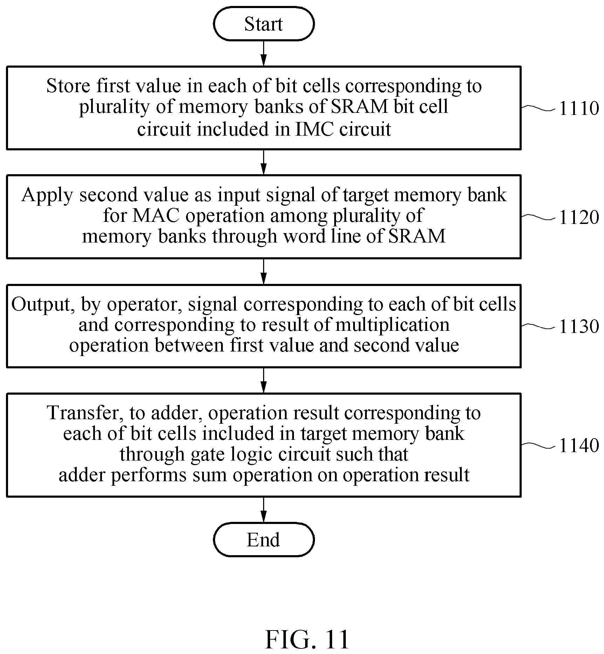

FIG. 11 illustrates an example of a method of operating an IMC circuit. In the following examples, operations may be performed sequentially, but not necessarily sequentially. For example, the order of the operations may be changed and at least two of the operations may be performed in parallel.

Referring to FIG. 11, an IMC circuit may perform a MAC operation by transferring an operation result corresponding to each of bit cells to an adder through operations 1110 to 1140. The IMC circuit may include an SRAM bit cell circuit and a gate logic circuit. The SRAM bit cell circuit may include, for example, bit cells corresponding to memory banks and operators that outputs a signal corresponding to an operation result corresponding to each of the bit cells. The bit cells may be grouped into word lines of the SRAM for each memory bank. The IMC circuit may correspond to, for example, any of the IMC circuits described above with reference to FIGS. 2 to 9, but is not necessarily limited thereto.

In operation 1110, the IMC circuit stores a first value in each of the bit cells corresponding to memory banks of the SRAM bit cell circuit. The IMC circuit may use an RW circuit to store the first value in each of the bit cells.

In operation 1120, the IMC circuit applies a second value as an input signal of a target memory bank for a MAC operation among the memory banks through a word line of the SRAM. The second value may be read from an input feature map stored in an IFM buffer through, for example, an input driver, but is not necessarily limited thereto.

In operation 1130, the IMC circuit outputs, by the operators, a signal corresponding to each of the bit cells and corresponding to a result of a multiplication operation between the first value and the second value. The operators may include a plurality of transistors outputting a signal corresponding to a multiplication operation result. The IMC circuit may output, through the operators, a signal corresponding to a result of a bit-wise multiplication operation between a first value stored in each of the bit cells corresponding to a corresponding memory bank among the plurality of memory banks and a second value applied as an input signal of the corresponding memory bank through the word line.

In operation 1140, the IMC circuit transfers, to the adder, the operation result corresponding to each of the bit cells included in the target memory bank through the gate logic circuit such that the adder performs a sum operation on the operation result. The adder may correspond to, for example, the adder 230 of FIG. 2, the adder 230 of FIG. 3, and/or the adder 440 of FIG. 4.

Thereafter, the adder may perform a sum operation on the operation result received in operation 1140, and store the sum operation result in an accumulator. The accumulator may correspond to, for example, the accumulator 240 of FIGS. 2A to 2D or FIG. 3.

The neural networks, the neural network apparatuses, the electronic systems, the IMC macro, the IMC circuits, the IMC devices, the memories, the storage devices, and other apparatuses, devices, units, modules, and components described herein with respect to FIGS. 1-11 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-11 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card or a micro card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the invention is defined by the enclosed claims.

## Claims

1. An in-memory computing circuit, comprising:
a plurality of memory banks (Bank 0-3), each memory bank including a bit cell (221, 310) configured to store a weight value and an operator (222, 320) configured to receive an input value, the operator (222, 320) being connected to the bit cell (221, 310) such that the operator (222, 320) upon receiving the input value outputs a logic operation result between the input value and the weight value; and
a logic gate (227) configured to receive the logic operation result of each of the memory banks (Bank 0-3).

2. The in-memory computing circuit of claim 1, wherein the logic operation result of each of the memory banks (Bank 0-3) is a NAND operation value for the input value and the weight value.

3. The in-memory computing circuit of claim 1 or 2, wherein the logic gate (227) is a NAND gate (430).

4. The in-memory computing circuit of one of claims 1 to 3, wherein the logic gate (227) is further configured to output a multiplication result between a weight value and an input value of a memory bank selected among the memory banks (Bank 0-3).

5. The in-memory computing circuit of claim 4, wherein each of the memory banks (Bank 0-3) not selected is configured to receive an input value of 0.

6. The in-memory computing circuit of one of claims 1 to 5, further comprising an adder (230) connected to the logic gate (227), and
wherein the logic gate (227) is configured to transfer, to the adder (230), the logic operation result corresponding to the bit cell (221, 310), according to whether the input value is applied to the operator (222, 320).

7. The in-memory computing circuit of one of claims 1 to 6, wherein the operator (222, 320) comprises:
a respective plurality of transistors configured to output a signal corresponding to a result of a bit-wise multiplication operation.

8. The in-memory computing circuit of one of claims 1 to 7, wherein the operator (222, 320) comprises a two transistor, 2T, circuit comprising a first transistor (321) and a second transistor (323), and
the input value is applied to a first gate terminal of the first transistor (321) and a second gate terminal of the second transistor (323), and
an output value of the first transistor (321) passing through the first gate terminal is connected to an output value of the second transistor (323) passing through the second gate terminal, and thereby output the logic operation result.

9. The in-memory computing circuit of claim 8, wherein a value based on the weight value stored in the bit cell (221, 310) is applied to a drain terminal of the first transistor (321), and a source terminal of the first transistor (321) is connected to an input terminal of the logic gate (227) via a drain terminal of the second transistor (323), and wherein the first transistor (321) comprises a negative-metal-oxide semiconductor, NMOS, transistor, and the second transistor (323) comprises a positive-MOS, PMOS, transistor.

10. The in-memory computing circuit of one of claims 1 to 7, wherein the operator (222, 320) comprises a three transistor, 3T, circuit comprising a transmission gate and a third transistor (713), and
the input value is applied to an enable terminal of the transmission gate and a third gate terminal of the third transistor (713), and
each of an output value of the transmission gate and an output value of the third transistor (713) passing through the third gate terminal is connected to the input of a gate logic circuit, and thereby output the logic operation result.

11. The in-memory computing circuit of one of claim 1 to 10 being integrated into at least one device selected from a group comprising: a mobile device, a mobile computing device, a mobile phone, a smartphone, a personal digital assistant, a fixed location terminal, a tablet computer, a computer, a wearable device, a laptop computer, a server, a music player, a video player, an entertainment unit, a navigation device, a communication device, a global positioning system, GPS, device, a television, a tuner, an automobile, a vehicle part, an avionics system, a drone, a multi-copter, and a medical device.

12. A neural network apparatus comprising an in-memory computing, IMC, circuit, the apparatus comprising:
an array circuit (910) comprising IMC circuits (915); and
a controller (930) configured to: input second values corresponding to an input signal of the neural network apparatus to each of the IMC circuits (915) according to a clock signal, and control the plurality of IMC circuits (915),
wherein each of the IMC circuits (915) is arranged in accordance with any one of claims 1 to 11.

13. The apparatus of claim 12, wherein the controller (930) comprises any one or any combination of:
an input feature map, IFM, buffer (931) configured to store an input feature map comprising the input value;
a control circuit (933) configured to control whether the input value is applied to the plurality of IMC circuits (915); and
a read write, RW, circuit (935) configured to read or write the weight value.

14. A method of operating an in-memory computing, IMC, apparatus that comprises memory banks (Bank 0-3), a logic gate (227) and an adder (230), each memory bank comprising a respective bit cell unit (223a-223d), each bit cell unit (223a-223d) comprising a bit cell (221, 310) and an operator (222, 320), wherein none of the bit cells share a same operator (222, 320), the method comprising:
receiving, by the logic gate (227), outputs of the operators (222, 320) of the respective bit cell units (223a-223d);
receiving, by the adder (230), an output of the logic gate (227); and
performing, by the adder (230), at least part of a multiply-accumulate, MAC, operation.

15. The method of claim 14 further comprising one or more of:
connecting an output of each of the respective bit cell units (223a-223d) to the logic gate (227);
storing, by each of the bit cells, a respective stored value; and
providing, by the bit cell units (223a-223d) that are connected to respective input lines, respective input values to the bit cell units (223a-223d) for selecting which one of the bit cell units (223a-223d) is a target for an operation to be performed on its stored value by its operator (222, 320), and the stored value of the bit cell units (223a-223d) that are not the target for the operation cannot affect an output of the logic gate (227).

## Patentansprüche

1. Schaltung zur speicherinternen Datenverarbeitung, umfassend:
eine Vielzahl von Speicherbänken (Bank 0-3), wobei jede Speicherbank eine Bitzelle (221, 310), die dazu eingerichtet ist, einen Gewichtswert zu speichern, und einen Operator (222, 320), der dazu eingerichtet ist, einen Eingangswert zu empfangen, umfasst, wobei der Operator (222, 320) mit der Bitzelle (221, 310) verbunden ist, sodass der Operator (222, 320) beim Empfangen des Eingangswerts ein Ergebnis einer logischen Operation zwischen dem Eingangswert und dem Gewichtswert ausgibt; und
ein Logikgatter (227), das dazu eingerichtet ist, das Ergebnis der logischen Operation jeder der Speicherbänke (Bank 0-3) zu empfangen.

2. Schaltung zur speicherinternen Datenverarbeitung nach Anspruch 1, wobei das Ergebnis der logischen Operation jeder der Speicherbänke (Bank 0-3) ein Wert einer NAND-Operation für den Eingangswert und den Gewichtswert ist.

3. Schaltung zur speicherinternen Datenverarbeitung nach Anspruch 1 oder 2, wobei das Logikgatter (227) ein NAND-Gatter (430) ist.

4. Schaltung zur speicherinternen Datenverarbeitung nach einem der Ansprüche 1 bis 3, wobei das Logikgatter (227) ferner dazu eingerichtet ist, ein Multiplikationsergebnis zwischen einem Gewichtswert und einem Eingangswert einer unter den Speicherbänken (Bank 0-3) ausgewählten Speicherbank auszugeben.

5. Schaltung zur speicherinternen Datenverarbeitung nach Anspruch 4, wobei jede der nicht ausgewählten Speicherbänke (Bank 0-3) dazu eingerichtet ist, einen Eingangswert von 0 zu empfangen.

6. Schaltung zur speicherinternen Datenverarbeitung nach einem der Ansprüche 1 bis 5, ferner umfassend einen Addierer (230), der mit dem Logikgatter (227) verbunden ist, und
wobei das Logikgatter (227) dazu eingerichtet ist, das der Bitzelle (221, 310) entsprechende Ergebnis der logischen Operation in Abhängigkeit davon, ob der Eingangswert an den Operator (222, 320) angelegt wird, an den Addierer (230) zu übertragen.

7. Schaltung zur speicherinternen Datenverarbeitung nach einem der Ansprüche 1 bis 6, wobei der Operator (222, 320) umfasst:
eine jeweilige Vielzahl von Transistoren, die dazu eingerichtet ist, ein Signal auszugeben, das einem Ergebnis einer bitweisen Multiplikationsoperation entspricht.

8. Schaltung zur speicherinternen Datenverarbeitung nach einem der Ansprüche 1 bis 7, wobei der Operator (222, 320) eine Zwei-Transistor-Schaltung (2T-Schaltung) umfasst, die einen ersten Transistor (321) und einen zweiten Transistor (323) umfasst, und
der Eingangswert an einen ersten Gate-Anschluss des ersten Transistors (321) und einen zweiten Gate-Anschluss des zweiten Transistors (323) angelegt wird, und
ein Ausgangswert des ersten Transistors (321), der den ersten Gate-Anschluss durchläuft, mit einem Ausgangswert des zweiten Transistors (323), der den zweiten Gate-Anschluss durchläuft, verbunden ist und dadurch das Ergebnis der logischen Operation ausgeben.

9. Schaltung zur speicherinternen Datenverarbeitung nach Anspruch 8, wobei ein Wert, der auf dem in der Bitzelle (221, 310) gespeicherten Gewichtswert basiert, an einen Drain-Anschluss des ersten Transistors (321) angelegt wird und ein Source-Anschluss des ersten Transistors (321) über einen Drain-Anschluss des zweiten Transistors (323) mit einem Eingangsanschluss des Logikgatters (227) verbunden ist, und wobei der erste Transistor (321) einen Negativ-Metalloxid-Halbleiter-, NMOS-, Transistor umfasst und der zweite Transistor (323) einen Positiv-MOS-, PMOS-, Transistor umfasst.

10. Schaltung zur speicherinternen Datenverarbeitung nach einem der Ansprüche 1 bis 7, wobei der Operator (222, 320) eine Drei-Transistor-Schaltung (3T-Schaltung) umfasst, die ein Transmissionsgatter und einen dritten Transistor (713) umfasst, und
der Eingangswert an einen Freigabeanschluss des Transmissionsgatters und einen dritten Gate-Anschluss des dritten Transistors (713) angelegt wird, und
jeweils ein Ausgangswert des Transmissionsgatters und ein Ausgangswert des dritten Transistors (713), der den dritten Gate-Anschluss durchläuft, mit dem Eingang einer Gatterlogikschaltung verbunden ist und dadurch das Ergebnis der logischen Operation ausgeben.

11. Schaltung zur speicherinternen Datenverarbeitung nach einem von Anspruch 1 bis 10, die in mindestens ein Gerät integriert ist, das aus einer Gruppe ausgewählt ist, umfassend: ein mobiles Gerät, ein mobiles Rechengerät, ein Mobiltelefon, ein Smartphone, einen persönlichen digitalen Assistenten, ein ortsfestes Endgerät, einen Tablet-Computer, einen Computer, ein am Körper tragbares Gerät, einen Laptop-Computer, einen Server, ein Musikabspielgerät, ein Videoabspielgerät, eine Unterhaltungseinheit, ein Navigationsgerät, ein Kommunikationsgerät, ein GPS-Gerät, ein Fernsehgerät, einen Tuner, ein Kraftfahrzeug, ein Fahrzeugteil, ein Avioniksystem, eine Drohne, einen Multikopter und ein medizinisches Gerät.

12. Neuronale Netzwerkvorrichtung, umfassend eine Schaltung zur speicherinternen Datenverarbeitung (IMC-Schaltung), wobei die Vorrichtung umfasst:
eine Array-Schaltung (910), die IMC-Schaltungen (915) umfasst; und
eine Steuereinheit (930), die dazu eingerichtet ist: zweite Werte, die einem Eingangssignal der neuronalen Netzwerkvorrichtung entsprechen, gemäß einem Taktsignal in jede der IMC-Schaltungen (915) einzugeben und die Vielzahl von IMC-Schaltungen (915) zu steuern,
wobei jede der IMC-Schaltungen (915) gemäß einem der Ansprüche 1 bis 11 angeordnet ist.

13. Vorrichtung nach Anspruch 12, wobei die Steuereinheit (930) eines oder eine beliebige Kombination von Folgendem umfasst:
einen Puffer für eine Eingangsmerkmalskarte, IFM, (931), der dazu eingerichtet ist, eine den Eingangswert umfassende Eingangsmerkmalskarte zu speichern;
eine Steuerschaltung (933), die dazu eingerichtet ist, zu steuern, ob der Eingangswert an die Vielzahl von IMC-Schaltungen (915) angelegt wird; und
eine Lese-/Schreibschaltung, RW, (935), die dazu eingerichtet ist, den Gewichtswert zu lesen oder zu schreiben.

14. Verfahren zum Betreiben einer Vorrichtung zur speicherinternen Datenverarbeitung (IMC-Vorrichtung), die Speicherbänke (Bank 0-3), ein Logikgatter (227) und einen Addierer (230) umfasst, wobei jede Speicherbank eine jeweilige Bitzelleneinheit (223a-223d) umfasst, wobei jede Bitzelleneinheit (223a-223d) eine Bitzelle (221, 310) und einen Operator (222, 320) umfasst, wobei keine der Bitzellen denselben Operator (222, 320) gemeinsam nutzt, wobei das Verfahren umfasst:
Empfangen, durch das Logikgatter (227), von Ausgaben der Operatoren (222, 320) der jeweiligen Bitzelleneinheiten (223a-223d);
Empfangen, durch den Addierer (230), einer Ausgabe des Logikgatters (227); und
Durchführen, durch den Addierer (230), wenigstens eines Teils einer Multiplikations-Akkumulations-Operation (MAC-Operation).

15. Verfahren nach Anspruch 14, ferner umfassend eines oder mehrere der Folgenden:
Verbinden eines Ausgangs jeder der jeweiligen Bitzelleneinheiten (223a-223d) mit dem Logikgatter (227);
Speichern eines jeweiligen gespeicherten Werts durch jede der Bitzellen; und
Bereitstellen, durch die Bitzelleneinheiten (223a-223d), die mit jeweiligen Eingangsleitungen verbunden sind, jeweiliger Eingangswerte an die Bitzelleneinheiten (223a-223d) zum Auswählen, welche der Bitzelleneinheiten (223a-223d) ein Ziel für eine durch ihren Operator (222, 320) an ihrem gespeicherten Wert durchzuführende Operation ist, und wobei der gespeicherte Wert der Bitzelleneinheiten (223a-223d), die nicht das Ziel für die Operation sind, einen Ausgang des Logikgatters (227) nicht beeinflussen kann.

## Revendications

1. Circuit de calcul en mémoire, comprenant :
une pluralité de bancs de mémoire (Bank 0-3), chaque banc de mémoire comprenant une cellule de bit (221, 310) configurée pour stocker une valeur de poids et un opérateur (222, 320) configuré pour recevoir une valeur d'entrée, l'opérateur (222, 320) étant connecté à la cellule de bit (221, 310) de telle sorte que l'opérateur (222, 320), lors de la réception de la valeur d'entrée, fournit en sortie un résultat d'opération logique entre la valeur d'entrée et la valeur de poids ; et
une porte logique (227) configurée pour recevoir le résultat de l'opération logique de chacun des bancs de mémoire (Bank 0-3).

2. Circuit de calcul en mémoire selon la revendication 1, dans lequel le résultat de l'opération logique de chacun des bancs de mémoire (Bank 0-3) est une valeur d'opération NAND pour la valeur d'entrée et la valeur de poids.

3. Circuit de calcul en mémoire selon la revendication 1 ou 2, dans lequel la porte logique (227) est une porte NAND (430).

4. Circuit de calcul en mémoire selon l'une quelconque des revendications 1 à 3, dans lequel la porte logique (227) est en outre configurée pour fournir en sortie un résultat de multiplication entre une valeur de poids et une valeur d'entrée d'un banc de mémoire sélectionné parmi les bancs de mémoire (Bank 0-3).

5. Circuit de calcul en mémoire selon la revendication 4, dans lequel chacun des bancs de mémoire (Bank 0-3) non sélectionnés est configuré pour recevoir une valeur d'entrée de 0.

6. Circuit de calcul en mémoire selon l'une quelconque des revendications 1 à 5, comprenant en outre un additionneur (230) connecté à la porte logique (227), et
dans lequel la porte logique (227) est configurée pour transférer, à l'additionneur (230), le résultat d'opération logique correspondant à la cellule de bit (221, 310), selon que la valeur d'entrée est appliquée ou non à l'opérateur (222, 320).

7. Circuit de calcul en mémoire selon l'une quelconque des revendications 1 à 6, dans lequel l'opérateur (222, 320) comprend :
une pluralité respective de transistors configurés pour fournir en sortie un signal correspondant à un résultat d'une opération de multiplication bit à bit.

8. Circuit de calcul en mémoire selon l'une quelconque des revendications 1 à 7, dans lequel l'opérateur (222, 320) comprend un circuit à deux transistors, 2T, comprenant un premier transistor (321) et un deuxième transistor (323), et
la valeur d'entrée est appliquée à une première borne de grille du premier transistor (321) et à une deuxième borne de grille du deuxième transistor (323), et
une valeur de sortie du premier transistor (321) passant par la première borne de grille est connectée à une valeur de sortie du deuxième transistor (323) passant par la deuxième borne de grille, et ainsi fournir en sortie le résultat de l'opération logique.

9. Circuit de calcul en mémoire selon la revendication 8, dans lequel une valeur basée sur la valeur de poids stockée dans la cellule de bit (221, 310) est appliquée à une borne de drain du premier transistor (321), et une borne de source du premier transistor (321) est connectée à une borne d'entrée de la porte logique (227) via une borne de drain du deuxième transistor (323), et dans lequel le premier transistor (321) comprend un transistor à semi-conducteur oxyde métallique négatif, NMOS, et le deuxième transistor (323) comprend un transistor MOS positif, PMOS.

10. Circuit de calcul en mémoire selon l'une quelconque des revendications 1 à 7, dans lequel l'opérateur (222, 320) comprend un circuit à trois transistors, 3T, comprenant une porte de transmission et un troisième transistor (713), et
la valeur d'entrée est appliquée à une borne d'activation de la porte de transmission et à une troisième borne de grille du troisième transistor (713), et
chacune d'une valeur de sortie de la porte de transmission et d'une valeur de sortie du troisième transistor (713) passant par la troisième borne de grille est connectée à l'entrée d'un circuit logique à portes, et ainsi fournir en sortie le résultat de l'opération logique.

11. Circuit de calcul en mémoire selon l'une de revendication 1 à 10, intégré dans au moins un dispositif sélectionné dans un groupe comprenant : un dispositif mobile, un dispositif informatique mobile, un téléphone mobile, un smartphone, un assistant numérique personnel, un terminal fixe, une tablette informatique, un ordinateur, un dispositif portable, un ordinateur portable, un serveur, un lecteur de musique, un lecteur vidéo, une unité de divertissement, un dispositif de navigation, un dispositif de communication, un dispositif GPS, un téléviseur, un syntoniseur, une automobile, une pièce de véhicule, un système avionique, un drone, un multicoptère et un dispositif médical.

12. Appareil de réseau neuronal comprenant un circuit de calcul en mémoire, IMC, l'appareil comprenant :
un circuit matriciel (910) comprenant des circuits IMC (915) ; et
un contrôleur (930) configuré pour : fournir en entrée à chacun des circuits IMC (915), selon un signal d'horloge, des secondes valeurs correspondant à un signal d'entrée de l'appareil de réseau neuronal, et commander la pluralité de circuits IMC (915),
dans lequel chacun des circuits IMC (915) est agencé conformément à l'une quelconque des revendications 1 à 11.

13. Appareil selon la revendication 12, dans lequel le contrôleur (930) comprend l'un quelconque ou toute combinaison parmi :
un tampon de carte de caractéristiques d'entrée, IFM, (931) configuré pour stocker une carte de caractéristiques d'entrée comprenant la valeur d'entrée ;
un circuit de commande (933) configuré pour commander si la valeur d'entrée est appliquée à la pluralité de circuits IMC (915) ; et
un circuit de lecture/écriture, RW, (935) configuré pour lire ou écrire la valeur de poids.

14. Procédé de fonctionnement d'un appareil de calcul en mémoire, IMC, qui comprend des bancs de mémoire (Bank 0-3), une porte logique (227) et un additionneur (230), chaque banc de mémoire comprenant une unité de cellule de bit respective (223a-223d), chaque unité de cellule de bit (223a-223d) comprenant une cellule de bit (221, 310) et un opérateur (222, 320), aucune des cellules de bit ne partageant un même opérateur (222, 320), le procédé comprenant :
la réception, par la porte logique (227), de sorties des opérateurs (222, 320) des unités de cellule de bit respectives (223a-223d) ;
la réception, par l'additionneur (230), d'une sortie de la porte logique (227) ; et
la réalisation, par l'additionneur (230), d'au moins une partie d'une opération de multiplication-accumulation, MAC.

15. Procédé selon la revendication 14, comprenant en outre un ou plusieurs parmi :
la connexion d'une sortie de chacune des unités de cellule de bit respectives (223a-223d) à la porte logique (227) ;
le stockage, par chacune des cellules de bit, d'une valeur stockée respective ; et
la fourniture, par les unités de cellule de bit (223a-223d) qui sont connectées à des lignes d'entrée respectives, de valeurs d'entrée respectives aux unités de cellule de bit (223a-223d) afin de sélectionner laquelle des unités de cellule de bit (223a-223d) est une cible d'une opération devant être effectuée sur sa valeur stockée par son opérateur (222, 320), et la valeur stockée des unités de cellule de bit (223a-223d) qui ne sont pas la cible de l'opération ne peut pas affecter une sortie de la porte logique (227).
